(19) Europäisches Patentamt
European Patent Office
Office européen des brevets

(11) **EP 3 236 713 B1**

(12) **EUROPÄISCHE PATENTSCHRIFT**

(45) Veröffentlichungstag und Bekanntmachung des Hinweises auf die Patenterteilung:
**11.03.2020 Patentblatt 2020/11**

(51) Int Cl.:
*H05B 33/08* *(2020.01)* *B61L 5/18* *(2006.01)*
*G01R 31/26* *(2020.01)*

(21) Anmeldenummer: **17167547.3**

(22) Anmeldetag: **21.04.2017**

(54) **FUNKTIONSÜBERWACHUNG VON LED-LICHTZEICHEN**

MONITORING THE FUNCTIONING OF A LED LIGHT SIGNAL

SURVEILLANCE DE FONCTIONNEMENT DE SIGNAUX LUMINEUX À DEL

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.04.2016 DE 102016206878**

(43) Veröffentlichungstag der Anmeldung:
**25.10.2017 Patentblatt 2017/43**

(73) Patentinhaber: **Siemens Mobility GmbH
81739 München (DE)**

(72) Erfinder:
• **Beringer, Stefan
82538 Geretsried (DE)**
• **Fischer, Michael
73312 Geislingen (DE)**

(56) Entgegenhaltungen:
WO-A1-2010/060458    WO-A2-2010/034509
US-A1- 2009 027 314    US-A1- 2016 103 170

**Beschreibung**

Die Erfindung betrifft ein Verfahren zum Überwachen der Funktion einer Leuchtdiodeneinheit. Zudem betrifft die Erfindung eine Testeinrichtung zur Überwachung einer Leuchtdiodeneinheit. Weiterhin betrifft die Erfindung eine Lichtzeichenanlage.

Zur Verkehrssteuerung werden häufig sogenannte Lichtsignaloder Lichtzeichenanlagen eingesetzt. Beispielsweise können damit standardisierte und allgemein bekannte Lichtsignale zur Regelung des Verkehrs weithin sichtbar angezeigt werden. Überdies können auch kurze schriftliche Botschaften mit Hilfe von Leuchtelementen an Schautafeln angezeigt werden, mit denen die Verkehrsteilnehmer Informationen über die aktuelle Verkehrslage, den Straßenzustand oder auch eine daran angepasste variable Geschwindigkeitsbegrenzung erhalten. Die Funktionsfähigkeit der dazu eingesetzten Leuchtdioden muss ständig überprüft werden, damit eine ständige Einsatzfähigkeit der Lichtzeichenanlage gewährleistet ist. Die Überwachung muss auch dann wirksam sein, wenn das entsprechende Zeichen nicht aktiv ist, also gerade nicht leuchtet.

Ein Problem besteht darin, dass bei völliger Dunkelheit bereits einzelne Stromimpulse, die sich im Nennstrombereich bewegen und länger als ca. 0,3 μs betragen, sowie selbst kleine Dauerströme von einigen μA bis mA je nach Nennstrom der Leuchtdioden störend bemerkbar machen. Deshalb wurde bisher die Funktionsüberwachung im ausgeschalteten Zustand durch Schaltungen realisiert, welche ausreichend kurze bzw. schwache Stromimpulse erzeugen und sicher überwachen können. Eine solche Schaltungsanordnung ist zum Beispiel in EP 1 417 864 B1 beschrieben. Da bei diesen herkömmlichen Verfahren als Überwachungskriterium ein kurzer Stromfluss durch die Leuchtdioden herangezogen wird, ergibt sich das Problem, dass sich bei dem Einsatz von längeren Zuleitungen zu den LED-Lichtzeichen die mit der Zuleitungslänge zunehmende Zuleitungskapazität, die sich prinzipiell damit parallel zum LED-Lichtzeichen befindet, derart auswirkt, dass bereits der Stromfluss durch diese Zuleitungskapazität eine solche Größenordnung annehmen kann, dass ein LED-Lichtzeichen als funktionstüchtig eingestuft wird, ohne dass durch die Leuchtdioden selbst überhaupt ein Teststrom geflossen ist. Möchte man diese fehlerhafte Meldung vermeiden, so müssen die Test-Stromimpulse vergrößert werden, was den bereits erwähnten Nachteil mit sich bringt, dass diese stärkeren Testimpulse bei völliger Dunkelheit als Lichtblitze störend bemerkbar sind.

Eine Möglichkeit zur Bewältigung des beschriebenen Problems besteht darin, die Länge der Zuleitungen zwischen der Ansteuerelektronik und den LED-Lichtzeichen derart zu beschränken, dass die durch die Zuleitungskapazität verursachten kapazitiven Ströme so gering sind, dass sie im Vergleich zu dem eigentlichen Teststrom durch die Leuchtdioden vernachlässigbar sind. Allerdings werden dadurch die Freiheit des Aufbaus und der Einsatzbereich der Lichtzeichenanlage eingeschränkt.

In US 2007 0 096 746 A1 ist eine Überwachungseinrichtung für eine Mehrzahl von Leuchtdioden beschrieben. Zur Überwachung wird während des Betriebs eine an den Leuchtdioden anliegende elektrische Gesamtspannung gemessen und mit einer elektrischen Referenzspannung verglichen.

In AT 512 751 A1 werden eine Schaltungsanordnung und ein Verfahren zum Testen der Funktion eines Leuchtdiodenzweigs beschrieben. Bei dem Testvorgang wird der Leuchtdiodenzweig von einem Betriebszustand, bei dem ein konstanter elektrischer Strom angelegt ist, in einen Testzustand unter Einprägung eines elektrischen Stroms mit einer anderen Stromstärke überführt, wobei unter Berücksichtigung einer direkten oder indirekten Messung einer elektrischen Größe der Schaltungsanordnung der Leuchtdiodenzweig getestet wird.

In EP 2 882 260 A1 wird eine Überwachungsschutzschaltung für Beleuchtungsanlagen beschrieben. Die Überwachungsschutzschaltung umfasst einen eine Beleuchtungseinheit ein- und ausschaltenden Lastschalter und ein strom- und/oder spannungsbegrenzendes Bauteil, welche so genutzt werden, dass bei Übereinstimmung der ermittelten Spannung über die Beleuchtungseinheit mit der erwarteten Spannung oder des ermittelten Stroms durch den Messpfad mit dem erwarteten Strom aus der Soll-Strom-Spannungskennlinie der Beleuchtungseinheit die Beleuchtungseinheit eingeschaltet und bei einer entsprechenden Abweichung die Beleuchtungseinheit unverzüglich ausgeschaltet wird.

In DE 10 2015 100 605 A1 wird ein Sensorschaltkreis zur Detektion eines Kurzschlusses einer optoelektronischen Baugruppe beschrieben.

In US 2015/0 331 034 A1 wird eine Einrichtung zur Problemerkennung in Stromversorgungsnetzen beschrieben. Die Einrichtung umfasst erste Schaltungen zum Beaufschlagen des Netzes mit einem Testsignal, zweite Schaltungen zur Detektion eines Messsignals in Antwort auf das Testsignal und dritte Schaltungen zum Detektieren von Problemen auf Basis von Änderungen von Parametern des Messsignals.

In US 2009/0 027 314 A1 wird eine Anordnung zur Überwachung der Funktionsfähigkeit von organischen Licht emittierenden Bauelementen beschrieben. Es wird ein konstanter Strom an die zu testenden Bauelemente angelegt und eine an den Bauelementen abfallende elektrische Spannung detektiert. Verschlechtern sich die elektrischen Eigenschaften der organischen Licht emittierenden Bauelemente, so wird auch eine Änderung der gemessenen elektrischen Spannung ermittelt.

In US 2016/0 103 170 A1 wird ein Verfahren zum Testen von organischen Licht emittierenden Dioden, auch OLEDs genannt, beschrieben. Bei dem Verfahren wird eine elektrische Spannung an die OLEDs angelegt. Weiterhin wird eine an den OLEDs abfallende elektrische Spannung und ein durch die OLEDs fließender elektrischer Strom gemessen. Auf Basis der Messwerte wird ein Parameter der OLEDS ermittelt und auf Basis dieses Parameters werden physikalische Eigenschaften der OLEDs extrahiert.

In WO 2010/034 509 A2 wird eine Messvorrichtung zum Bestimmen der elektrischen Eigenschaften einer OLED beschrieben.

In WO 2010/060 458 A1 wird eine Vorrichtung zum Detektieren von defekten OLEDs beschrieben. Die Vorrichtung umfasst eine Teststromquelle, die einen Strom an die zu testende OLED bereitstellt, dessen Stärke unterhalb des Einsatzpunkts einer intakten OLED liegt. Die Vorrichtung umfasst auch eine Referenzspannungsvorrichtung, welche eine vorgebbare Referenzspannung bereitstellt. Zudem weist die Vorrichtung eine Vergleichsvorrichtung zum Vergleich einer an der OLED abfallenden elektrischen Spannung mit der Referenzspannung auf.

Es ist somit eine Aufgabe der vorliegenden Erfindung, ein Testverfahren und eine Überwachungsschaltung anzugeben, mit der eine zuverlässigere und flexibler einsetzbare Überwachung von Leuchtdioden in Lichtzeichenanlagen erreicht wird.

Diese Aufgabe wird durch ein Verfahren zum Überwachen der Funktion einer Leuchtdiodeneinheit gemäß Patentanspruch 1, eine Testeinrichtung gemäß Patentanspruch 11 und eine Lichtzeichenanlage gemäß Patentanspruch 13 und einem Computerprogrammprodukt gemäß Patentanspruch 14 gelöst.

Bei dem erfindungsgemäßen Verfahren zum Überwachen der Funktion einer Leuchtdiodeneinheit erfolgt in einem kurzen Testintervall, das zum Beispiel wenige µs dauert, ein kurzer Test der Leuchtdiodeneinheit. Die Leuchtdiodeneinheit kann zum Beispiel im ausgeschalteten Zustand überwacht bzw. getestet werden. Oft ist eine Leuchtdiodeneinheit eines LED-Lichtzeichens länger, zum Beispiel Stunden, Tage oder Wochen ausgeschaltet, wenn das LED-Lichtzeichen selten benötigt wird. Beispielsweise ist dies der Fall bei einem "STOPP"-Zeichen am Tunnelportal, welches nur dann leuchtet, wenn es im Tunnel brennt oder es dort einen Unfall gegeben hat.

Dafür wird in diesem Testintervall zunächst ein erster Konstantstrom an eine Zuleitung der Leuchtdiodeneinheit angelegt. Als Konstantstrom soll in diesem Zusammenhang ein elektrischer Strom verstanden werden, der nach dem Einschalten während des Testintervalls eine konstante Stromstärke aufweist. Beispielsweise kann hierfür eine Stromquelle mit Hilfe eines Steuerpulses angesteuert werden, welcher zeitlich mit dem Testintervall korreliert ist. Zunächst erfolgt ein Aufladen der durch die Zuleitung sowie die Leuchtdiodeneinheit gebildeten Kapazität durch den ersten Konstantstrom. Während des Ladevorgangs wird dann eine an der Zuleitung anliegende externe elektrische Ladespannung ermittelt. Als Ladespannung soll in diesem Zusammenhang eine durch das Aufladen der betreffenden Kapazität auftretende elektrische Spannung verstanden werden. Diese kann zum Beispiel im Fall der Zuleitungskapazität eine elektrische Spannung gegen ein Referenzpotential, zum Beispiel Masse, sein. Hat die an der Zuleitung anliegende externe elektrische Ladespannung einen Wert erreicht, der dem Wert der Durchlassspannung bzw. Durchlassspannung der Leuchtdioden entspricht, so erhöht sich die externe elektrische Ladespannung nicht weiter. Auf diese Weise bildet sich ein konstanter Wert der Ladespannung aus, der als Anzeichen für ein korrektes Funktionieren der Leuchtdioden betrachtet werden kann.

Auf Basis des ermittelten Spannungswerts wird ein Vergleich auf Basis der ermittelten externen elektrischen Ladespannung und einem Referenzwert durchgeführt und eine korrekte Funktion der Leuchtdiodeneinheit in Abhängigkeit von einem Vergleichsergebnis ermittelt. D.h., für den Fall, dass auf Basis des Vergleichs ermittelt wurde, dass ein Kriterium für die Funktionsfähigkeit der Leuchtdioden erfüllt wurde, wird festgestellt, dass die Leuchtdiodeneinheit korrekt funktioniert. Wird dieses Kriterium in einer vorbestimmten Zeit, vorzugsweise einer Zeitspanne, die kürzer als das Testintervall ist, nicht erfüllt, so wird dadurch festgestellt, dass die Leuchtdiodeneinheit nicht korrekt funktioniert. Unter einer korrekten Funktion soll in diesem Zusammenhang insbesondere verstanden werden, dass die Leuchtdioden bei einer Durchlassspannung in den leitenden Zustand übergehen.

Vorteilhaft wird bei dem erfindungsgemäßen Testverfahren nicht direkt ein die Leuchtdioden durchfließender elektrischer Strom gemessen, sondern nur eine an der Zuleitung zur Leuchtdiodeneinheit anliegende Ladespannung. Dabei kann eine Funktionsfähigkeit der Leuchtdioden bereits ermittelt werden, bevor ein signifikanter elektrischer Strom durch die Leuchtdioden fließt. Als signifikanter elektrischer Strom soll ein Strom angesehen werden, welcher eine Leuchtwirkung aufweist, die von dem menschlichen Auge wahrgenommen werden kann. Auf diese Weise können Irritationen von Verkehrsteilnehmern, insbesondere bei Dunkelheit, infolge eines unerwünschten Aufleuchtens der Leuchtdiodeneinheit im Testbetrieb vermieden werden. Weiterhin ist das Testverfahren auch gut geeignet für Lichtzeichenanlagen mit langen Zuleitungen. Diese weisen höhere Kapazitäten auf und erfordern bei herkömmlichen Testverfahren stärkere Testströme, welche die bereits erwähnten nachteiligen Lichterscheinungen verursachen. Da bei dem erfindungsgemäßen Testverfahren kein signifikanter Strom durch die Leuchtdioden fließt, treten diese unterwünschten Nebeneffekte bei diesem Verfahren nicht mehr auf. Das erfindungsgemäße Testverfahren lässt sich also breiter anwenden und bietet dabei eine verbesserte Zuverlässigkeit und/oder Sicherheit für die Verkehrsteilnehmer.

Ist das LED-Lichtzeichen dagegen normal eingeschaltet, kann die Funktionsüberwachung auch durch eine Strom- und Spannungsmessung mit Hilfe der im Normalbetrieb verwendeten Ansteuerungseinheit der betreffenden Lichtzeichenanlage erfolgen.

Allerdings kann es im Normalbetrieb bei einer Überwachung allein durch die Ansteuerungseinheit vorkommen, dass die Spannungsmessung einen Kurzschluss in der LED nicht erkennen kann, da im Normalbetrieb mit den hohen LED-Strömen der Spannungsabfall am Zuleitungswiderstand viel größer als die eigentliche LED-Flussspannung ist. Dieser Kurzschluss kann vorteilhaft durch die Testeinrichtung festgestellt werden, da diese mit sehr kleinen Strömen im Bereich von einigen mA misst und dabei dann der Spannungsabfall am Zuleitungswiderstand vernachlässigt werden kann. Dazu wird in einem kurzen Testintervall die Leuchtdiodeneinheit ausgeschaltet und es erfolgt in dem kurzen Testintervall das erfindungsgemäße Testverfahren. Ein typischer Ablauf zwischen zeitlich getrennter Ansteuerung der LED durch die Ansteuerungseinheit oder durch die Testeinrichtung kann z.B. wie folgt aussehen: Die LED wird mit 100Hz PWM angesteuert; d.h. ein Intervall dauert 10ms, wobei die LED 9ms eingeschaltet wird (durch Ansteuereinheit) und die LED wird innerhalb 1ms, in der die LED ausgeschaltet ist, durch die Testeinrichtung auf Durchfluss und eventuell auch auf eine Mindestspannung (Kurzschlusstest) geprüft.

Die erfindungsgemäße Testeinrichtung zur Überwachung einer Leuchtdiodeneinheit umfasst eine interne Referenzkapazität. Als Leuchtdiodeneinheit soll eine Beleuchtungseinheit mit einer einzelnen Leuchtdiode oder einer seriell geschalteten Gruppe von Leuchtdioden verstanden werden. Eine Leuchtdiodeneinheit kann auch parallel geschaltete Leuchtdioden umfassen. Allerdings wird mit der erfindungsgemäßen Testeinrichtung in diesem speziellen Fall nur ermittelt, ob mindestens eine der parallel geschalteten Leuchtdioden in Ordnung ist und die anderen parallel geschalteten Leuchtdioden keinen Kurzschluss aufweisen. Weiterhin weist die erfindungsgemäße Testeinrichtung zumindest eine erste Konstantstromquelle zum Anlegen eines ersten Konstantstroms an eine Zuleitung der Leuchtdiodeneinheit zum Aufladen einer von der Zuleitung und gegebenenfalls der Leuchtdiodeneinheit gebildeten Kapazität durch den ersten Konstantstrom auf. Teil der erfindungsgemäßen Testeinrichtung ist außerdem eine Messeinheit. Die Messeinheit umfasst einen Eingang, an dem eine an der Zuleitung der Leuchtdiodeneinheit abfallende externe elektrische Ladespannung anliegt.

Zudem weist die Messeinheit auch eine Spannungsvergleichseinheit zum Durchführen eines Spannungsvergleichs auf Basis einer zeitlichen Ableitung der externen elektrischen Ladespannung und einem Referenzwert auf. Die Messeinheit kann zum Beispiel als Schalter, beispielsweise in Form eines Transistors, ausgestaltet sein. Überdies umfasst die erfindungsgemäße Testeinrichtung eine Auswerteeinheit zum Ermitteln einer korrekten Funktion der Leuchtdiodeneinheit in Abhängigkeit von einem Vergleichsergebnis.

Die erfindungsgemäße Lichtzeichenanlage weist eine Lichtzeichenanzeige mit einer Leuchtdiodeneinheit auf. Zudem umfasst die erfindungsgemäße Lichtzeichenanlage eine Ansteuerungseinheit zum Ansteuern der Leuchtdiodeneinheit im Normalbetrieb. Zusätzlich weist die erfindungsgemäße Lichtzeichenanlage eine erfindungsgemäße Testeinrichtung auf. Wie bereits erwähnt, erlaubt der Einsatz der erfindungsgemäßen Testeinrichtung die Überwachung von Lichtzeichenanlagen mit sehr langen Zuleitungen, ohne dass unerwünschte Lichterscheinungen während des Testvorgangs in Kauf genommen werden müssen.

Die Komponenten der erfindungsgemäßen Testeinrichtung können zum Teil in Form von Softwarekomponenten ausgebildet sein. Dies betrifft insbesondere Teile der Messeinheit und der Auswerteeinheit. Grundsätzlich können diese Komponenten aber auch zum Teil, insbesondere wenn es um besonders schnelle Berechnungen geht, in Form von softwareunterstützter Hardware, beispielsweise FPGAs oder dergleichen, realisiert sein.

Eine teilweise softwaremäßige Realisierung hat den Vorteil, dass eine Testeinrichtung an verschiedene Testparameter leicht angepasst werden kann. Zum Beispiel können unterschiedliche Schwellwerte oder Testwerte leicht geändert werden, ohne dass die Hardware modifiziert werden muss. Weiterhin kann eine teilweise softwaremäßige Realisierung den Vorteil haben, dass auch schon bisher verwendete Testeinrichtungen nach einer Hardwaremodifikation, beispielsweise durch Hinzufügung einer Stromquelle und eventuell weiterer Hardwarebauelemente, auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in eine Speichereinrichtung einer erfindungsgemäßen Testeinrichtung ladbar ist, mit Programmabschnitten, um alle Schritte des erfindungsgemäßen Verfahrens auszuführen, wenn das Programm in der Testeinrichtung ausgeführt wird. Ein solches Computerprogrammprodukt kann neben dem Computerprogramm gegebenenfalls zusätzliche Bestandteile wie z.B. eine Dokumentation und/oder zusätzliche Komponenten auch Hardware-Komponenten, wie z.B. Hardware-Schlüssel (Dongles etc.) zur Nutzung der Software, umfassen.

Zum Transport zu der Testeinrichtung und/oder zur Speicherung an oder in der Testeinrichtung kann ein computerlesbares Medium, beispielsweise ein Memorystick, eine Festplatte oder ein sonstiger transportabler oder fest eingebauter Datenträger dienen, auf welchem die von einer Rechnereinheit der Testeinrichtung einlesbaren und ausführbaren Programmabschnitte des Computerprogramms gespeichert sind. Die Rechnereinheit kann z.B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie weitergebildet sein. Zudem können im Rahmen der Erfindung auch die verschiedenen Merkmale unterschiedlicher Ausführungsbeispiele und Ansprüche auch zu neuen Ausführungsbeispielen kombiniert werden.

In einer Ausgestaltung des erfindungsgemäßen Verfahrens wird zeitgleich zu dem Anlegen eines ersten Konstantstroms an eine Zuleitung der Leuchtdiodeneinheit auch ein zweiter Konstantstrom an eine Referenzkapazität angelegt. Für das Erzeugen des zusätzlichen zweiten Konstantstroms kann beispielsweise dieselbe Stromquelle wie für die Erzeugung des ersten Konstantstroms genutzt werden, oder es kann auch eine zusätzliche zweite Konstantstromquelle verwendet werden. Zunächst erfolgt ein Aufladen der durch die Zuleitung sowie die Leuchtdiodeneinheit gebildeten Kapazität durch den ersten Konstantstrom und zeitgleich ein Aufladen der Referenzkapazität durch den zweiten Konstantstrom. Während des Ladevorgangs wird dann eine an der Zuleitung anliegende externe elektrische Ladespannung ermittelt. Zugleich wird auch eine an der Referenzkapazität anliegende interne elektrische Ladespannung ermittelt. Als Ladespannung soll in diesem Zusammenhang eine durch das Aufladen der jeweiligen Kapazität auftretende elektrische Spannung verstanden werden. Diese kann, wie bereits erwähnt, zum Beispiel im Fall der Zuleitungskapazität eine elektrische Spannung gegen ein Referenzpotential sein oder im Fall der Referenzkapazität eine zwischen den Kondensatorelektroden anliegende elektrische Spannung sein. Hat die an der Zuleitung anliegende externe elektrische Ladespannung einen Wert erreicht, der dem Wert der Durchlassspannung bzw. Durchlassspannung der Leuchtdioden entspricht, so erhöht sich die externe elektrische Ladespannung nicht weiter, die interne Ladespannung an der Referenzkapazität steigt jedoch weiter an. Auf diese Weise bildet sich zwischen den beiden Ladespannungen eine zunehmende Differenz aus, die als Anzeichen für ein korrektes Funktionieren der Leuchtdioden betrachtet werden kann.

Auf Basis der ermittelten Werte wird ein Vergleich zwischen der externen elektrischen Ladespannung und der internen elektrischen Ladespannung der Referenzkapazität durchgeführt und eine korrekte Funktion der Leuchtdiodeneinheit in Abhängigkeit von einem Vergleichsergebnis ermittelt. D.h., für den Fall, dass auf Basis des Vergleichs ermittelt wurde, dass ein Kriterium für die Funktionsfähigkeit der Leuchtdioden erfüllt wurde, wird festgestellt, dass die Leuchtdiodeneinheit korrekt funktioniert. Wird dieses Kriterium in einer vorbestimmten Zeit, vorzugsweise einer Zeitspanne, die kürzer als das Testintervall ist, nicht erfüllt, so wird dadurch festgestellt, dass die Leuchtdiodeneinheit nicht korrekt funktioniert. Unter einer korrekten Funktion soll in diesem Zusammenhang insbesondere verstanden werden, dass die Leuchtdioden bei einer Durchlassspannung in den leitenden Zustand übergehen.

Vorteilhaft wird auch bei dieser Variante des erfindungsgemäßen Testverfahrens nicht direkt ein die Leuchtdioden durchfließender elektrischer Strom gemessen, sondern nur eine an der Zuleitung zur Leuchtdiodeneinheit anliegende Ladespannung und zum Vergleich eine elektrische Ladespannung an einer Referenzkapazität. Dabei kann eine Funktionsfähigkeit der Leuchtdioden bereits ermittelt werden, bevor ein signifikanter elektrischer Strom durch die Leuchtdioden fließt. Als signifikanter elektrischer Strom soll ein Strom angesehen werden, welcher eine Leuchtwirkung aufweist, die von dem menschlichen Auge wahrgenommen werden kann. Auf diese Weise können Irritationen von Verkehrsteilnehmern, insbesondere bei Dunkelheit, infolge eines unerwünschten Aufleuchtens der Leuchtdiodeneinheit im Testbetrieb vermieden werden. Weiterhin ist das Testverfahren auch gut geeignet für Lichtzeichenanlagen mit langen Zuleitungen. Diese weisen höhere Kapazitäten auf und erfordern bei herkömmlichen Testverfahren stärkere Testströme, welche die bereits erwähnten nachteiligen Lichterscheinungen verursachen. Da auch bei dieser Variante des erfindungsgemäßen Testverfahrens kein signifikanter Strom durch die Leuchtdioden fließt, treten diese unterwünschten Nebeneffekte bei diesem Verfahren nicht mehr auf. Auch diese Variante des erfindungsgemäßen Testverfahrens lässt sich also breiter anwenden und bietet dabei eine verbesserte Zuverlässigkeit und/oder Sicherheit für die Verkehrsteilnehmer. Die Referenzkapazität sowie eventuelle in Serie mit der Referenzkapazität und der Leitungskapazität geschaltete Widerstände sollten bei dieser Variante derart gewählt sein, dass eine Ladespannung der Referenzkapazität der Ladespannung der Zuleitungskapazität zunächst vom Wert her hinterherläuft. Erst wenn die Durchlassspannung durch die Ladespannung der Zuleitungskapazität erreicht ist und dieser Wert nicht mehr steigt, erhöht sich die Ladespannung an der Referenzkapazität weiter und übersteigt schließlich den Wert der Ladespannung der Zuleitungskapazität. Wie bereits erwähnt, kann dann durch einen Vergleich der beiden Ladespannungen auf ein Fließen eines Durchlassstroms der Leuchtdioden der zu testenden Leuchtdiodeneinheit geschlossen werden.

In einer Ausgestaltung des erfindungsgemäßen Verfahrens zum Überwachen der Funktion einer Leuchtdiodeneinheit wird bei dem Vergleichsschritt eine Spannungsdifferenz zwischen der externen elektrischen Ladespannung und der internen elektrischen Ladespannung ermittelt. Wie bereits erwähnt, bildet sich nach dem Erreichen der Durchlassspannung der Leuchtdioden eine Spannungsdifferenz zwischen der externen elektrischen Ladespannung und der internen elektrischen Ladespannung aus. Das Ausbilden dieser Differenz kann nun als Hinweis auf ein korrektes Funktionieren der Leuchtdiodeneinheit interpretiert werden. Sinnvoll ist es, den Wert der Referenzkapazität größer zu wählen als die Leitungskapazität, da dann vermieden werden kann, dass sich die Referenzkapazität vor dem Erreichen der Durchlassspannung schneller auflädt als die Leitungskapazität. In diesem Fall könnte sich sonst bereits vor dem Erreichen der Durchlassspannung eine positive Differenz zwischen der internen Ladespannung und der externen Ladespannung bilden, was dann fälschlicherweise als Nachweis für ein korrektes Funktionieren der Leuchtdiodeneinheit aufgefasst werden könnte. Wird jedoch die Referenzkapazität entsprechend größer als die Zuleitungskapazität gewählt, so wird garantiert, dass bis zum Zeitpunkt des Erreichens der Durchlassspannung die interne Ladespannung niedriger ist als die externe Ladespannung, so dass eine fehlerhafte Meldung einer korrekten Funktion der Leuchtdiodeneinheit verhindert wird. Weiterhin ist es bevorzugt, dass bei dem erfindungsgemäßen Verfahren zum Überwachen der Funktion einer Leuchtdiodeneinheit das Ermitteln einer korrekten Funktion einen Vergleich der ermittelten Spannungsdifferenz mit einem vorbestimmten Schwellwert umfasst. Ein solcher Schwellwert wird vorteilhafterweise derart gewählt, dass dieser Schwellwert bei korrekter Funktion der Leuchtdioden erreicht wird, bevor ein signifikanter Strom durch die Leuchtdiodeneinheit fließt. Auf diese Weise kann ein unerwünschtes kurzzeitiges Aufleuchten der Leuchtdiodeneinheit vermieden werden.

Besonders effektiv kann das erfindungsgemäße Verfahren zum Überwachen der Funktion einer Leuchtdiodeneinheit ausgeführt werden, wenn eine den ersten und/oder den zweiten Konstantstrom erzeugende Konstantstromquelle abgeschaltet wird, wenn die ermittelte Spannungsdifferenz den vorbestimmten Schwellwert erreicht hat. Beispielsweise kann nach dem Ermitteln einer korrekten Funktion der Leuchtdiodeneinheit sofort ein Steuersignal an die Konstantstromquelle gesendet werden, die Stromerzeugung zu beenden. Auf diese Weise bleibt die Konstantstromquelle nicht länger als nötig in Betrieb und versorgt die Leuchtdiodeneinheit auch nicht mehr weiter mit elektrischem Strom, so dass das Fließen eines signifikanten Stroms durch die Leuchtdiodeneinheit verhindert werden kann. Mithin wird ein vom menschlichen Auge wahrnehmbares Aufleuchten oder Aufblitzen der Leuchtdioden verhindert oder zumindest reduziert.

In einer Variante des erfindungsgemäßen Verfahrens zum Überwachen der Funktion einer Leuchtdiodeneinheit wird die Leitungskapazität nach Erreichen einer Durchlassspannung der Leuchtdiodeneinheit aufgrund des einsetzenden Stromflusses durch die Leuchtdioden der Leuchtdiodeneinheit nicht weiter aufgeladen und gleichzeitig wird die interne Referenzkapazität durch den zweiten Konstantstrom weiter aufgeladen, sodass die zu ermittelnde Spannungsdifferenz zwischen der externen elektrischen Ladespannung und der internen elektrischen Ladespannung entsteht. Vorteilhaft steigt die an der Leuchtdiodeneinheit anliegende elektrische Spannung nicht signifikant über die Durchlassspannung der Leuchtdiodeneinheit an, so dass kein signifikanter Strom durch die Leuchtdiodeneinheit fließt und damit ein sichtbares Aufleuchten der Leuchtdioden im Testbetrieb verhindert werden kann.

Vorzugsweise erfolgt also das Abschalten der Konstantstromquelle, bevor ein signifikanter Stromfluss durch die Leuchtdioden der Leuchtdiodeneinheit entsteht, so dass ein für das menschliche Auge wahrnehmbarer Lichtblitz vermieden werden kann. Diese Eigenschaft des erfindungsgemäßen Verfahrens ist insbesondere bei der Überwachung von Lichtzeichen im Dunkeln vorteilhaft, da in einer solchen Situation Lichterscheinungen für Verkehrsteilnehmer besonders irritierend und gefährlich sein können.

In einer vorteilhaften Variante des erfindungsgemäßen Verfahrens zum Überwachen der Funktion einer Leuchtdiodeneinheit wird für den Fall, dass nach einem vorbestimmten Zeitintervall keine Überschreitung des vorbestimmten Schwellwerts durch die ermittelte Spannungsdifferenz ermittelt wurde, ein Defekt der Leuchtdiodeneinheit festgestellt. Da für den Fall einer Fehlfunktion der Leuchtdioden keine Überschreitung des vorbestimmten Schwellwerts gemessen wird, wird das Verstreichen eines vorbestimmten Zeitintervalls, das kürzer ist, als das Testintervall, als Hinweis dafür verstanden, dass ein Defekt in der Leuchtdiodeneinheit vorliegt. Das vorbestimmte Zeitintervall sollte mindestens derart dimensioniert sein, dass bei dem Aufladevorgang der Zuleitungskapazität eine Durchlassspannung $U_{DL}$ der Leuchtdiodeneinheit, die zum Beispiel eine Summe der einzelnen Durchlassspannungen von in Reihe geschalteten Leuchtdioden der Leuchtdiodeneinheit sein kann, überschritten ist. Bei einem Anliegen des ersten Konstantstroms $I_{Test1}$ ergibt sich die nach einer Zeit t an der Zuleitungskapazität $C_L$ anliegende elektrische Spannung $U_{Ext}$ zu

$$U_{Ext} \ = \ I_{Test1} \ / \ C_L \ * \ t, \qquad\qquad (1)$$

so dass sich die minimale Testzeit $t_{min}$ zu

$$t_{min} \ = \ U_{DL} \ * \ C_L \ / \ I_{Test1} \qquad\qquad (2)$$

ergibt. Mithin sollte die Stärke des ersten Konstantstroms $I_{Test1}$ derart in Abhängigkeit von der Zuleitungskapazität $C_L$ und der Durchlassspannung $U_{DL}$ der Leuchtdiodeneinheit gewählt werden, dass die minimale Testzeit $t_{min}$ deutlich unter einer maximal zur Verfügung stehenden Testzeit eines Testintervalls liegt. In diesem Zusammenhang soll erwähnt werden, dass bei dem genannten Aufladevorgang natürlich auch eine der Leuchtdiodeneinheit zuzuordnende Kapazität mitaufgeladen wird. Diese ist jedoch in der Regel im Vergleich zu der Leitungskapazität so gering, dass sie vernachlässigbar ist.

In einer besonders vorteilhaften Variante des erfindungsgemäßen Verfahrens zum Überwachen der Funktion einer Leuchtdiodeneinheit wird ein Wert einer an der Leuchtdiodeneinheit abfallenden elektrischen Spannung ermittelt, der ermittelte Spannungswert mit einem Mindestspannungswert verglichen und es wird in Abhängigkeit von dem Vergleich zwischen dem ermittelten Spannungswert und dem Mindestspannungswert ermittelt, ob in der Leuchtdiodeneinheit ein elektrischer Kurzschluss vorliegt oder nicht. Bei dieser Variante wird also zusätzlich zu einer Prüfung der Leuchtdioden auf Durchlässigkeit auch getestet, ob eventuell in einer der Leuchtdioden ein Kurzschluss auftritt. In diesem Fall könnte nämlich der Vergleich der Ladespannungen auch dann ein positives Ergebnis einer korrekten Funktion der Leuchtdiodeneinheit liefern, wenn ein Durchlass aller Leuchtdioden gewährleistet ist, aber ein Kurzschluss in einer der Leuchtdioden vorliegt. Mit dem zusätzlichen Überprüfen der Leuchtdiodeneinheit auf einen Kurzschluss wird also die Zuverlässigkeit des erfindungsgemäßen Testverfahrens weiter verbessert. Ob ein Kurzschluss einer LED oder mehrerer in Reihe geschalteter LEDs festgestellt wird, hängt von dem Mindestspannungswert ab. Als einfach zu realisierende Lösung kann man auf mindestens eine "letzte" nicht kurzgeschlossene LED prüfen. Wenn man aber den Kurzschluss jeder einzelnen LED in einer Reihe von LEDs erkennen will, muss die Flussspannung aller LEDs analog gemessen werden und dann mit einem parametrierbaren Mindestwert verglichen werden.

In einer ebenfalls sehr vorteilhaften Ausgestaltung des erfindungsgemäßen Verfahrens wird für den Fall, dass ermittelt wird, dass nach einem vorbestimmten Zeitintervall entweder der vorbestimmte Schwellwert durch die ermittelte Spannungsdifferenz nicht erreicht wurde oder der Wert der an der Leuchtdiodeneinheit abfallenden elektrischen Spannung den vorbestimmten Mindestspannungswert nicht erreicht hat, ein Defekt der Leuchtdiodeneinheit festgestellt. Vorteilhaft werden bei dieser Variante also unterschiedliche Fehlfunktionen erfasst und bereits bei dem Vorliegen einer Art von Fehlfunktion eine Fehlermeldung ausgegeben.

In einer speziellen Ausgestaltung der erfindungsgemäßen Testeinrichtung weist die Testeinrichtung eine zusätzliche Kurzschlussermittlungsschaltung auf. Die Kurzschlussermittlungsschaltung umfasst einen ersten Eingang, an dem eine an der Leuchtdiodeneinheit abfallende elektrische Spannung anliegt, einen zweiten Eingang, an dem eine Referenzspannung anliegt, und eine Vergleichseinheit, welche dazu eingerichtet ist, einen Vergleich der Spannungswerte der an der Leuchtdiodeneinheit abfallenden elektrischen Spannung und der Referenzspannung durchzuführen. Weiterhin ist in dieser Ausgestaltung die Auswerteeinheit dazu eingerichtet, in Abhängigkeit von dem ermittelten Vergleichsergebnis zu ermitteln, ob in der Leuchtdiodeneinheit ein elektrischer Kurzschluss vorliegt oder nicht. Die Auswerteeinheit hat also zusätzlich zu der Auswertung des Vergleichsergebnisses bei dem Test auf Durchlass der Leuchtdioden noch die Fähigkeit, auch einen Kurzschluss zu ermitteln. Dabei wird in Abhängigkeit von einer Überschreitung einer vorbestimmten Minimalspannung, welche an den Leuchtdioden abfällt, ermittelt, ob ein Kurzschluss in einer der Leuchtdioden vorliegt oder nicht.

Die Erfindung wird im Folgenden unter Hinweis auf die beigefügten Figuren anhand von Ausführungsbeispielen noch einmal näher erläutert. Es zeigen:

FIG 1    ein Blockdiagramm, welches eine Schaltungsanordnung mit einer Testeinrichtung für eine Leuchtdiodeneinheit einer Lichtzeichenanlage gemäß einem Ausführungsbeispiel der Erfindung veranschaulicht,

FIG 2    einen Schaltplan, welcher Details einer Testeinrichtung gemäß einem Ausführungsbeispiel der Erfindung veranschaulicht,

FIG 3    ein Flussdiagramm, welches ein Verfahren zur Überwachung einer Leuchtdiodeneinheit einer Lichtzeicheneinrichtung gemäß einem Ausführungsbeispiel der Erfindung veranschaulicht,

FIG 4    ein Blockdiagramm, welches eine Schaltungsanordnung mit einer Testeinrichtung für eine Leuchtdiodeneinheit einer Lichtzeichenanlage gemäß einem weiteren Ausführungsbeispiel der Erfindung veranschaulicht,

FIG 5    ein Blockdiagramm, welches eine Schaltungsanordnung mit einer Testeinrichtung mit einer variablen Spannungsquelle für eine Leuchtdiodeneinheit einer Lichtzeichenanlage gemäß einem alternativen Ausführungsbeispiel der Erfindung veranschaulicht.

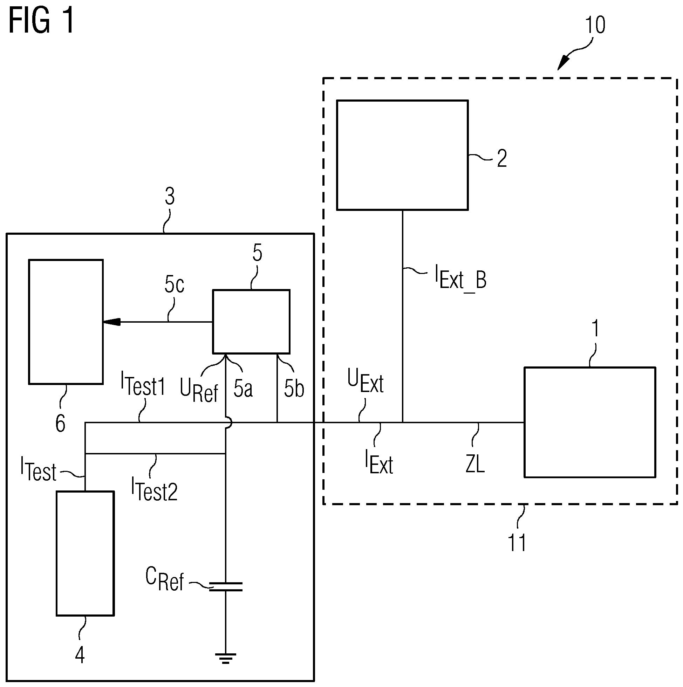

In FIG 1 ist ein Blockdiagramm gezeigt, welches eine Schaltungsanordnung 10 zur Überwachung und Ansteuerung einer Lichtzeichenanlage 11 gemäß einem Ausführungsbeispiel der Erfindung veranschaulicht. Die Schaltungsanordnung 10 umfasst eine Testeinrichtung 3 zur Überwachung einer Leuchtdiodeneinheit 1 der Lichtzeichenanlage 11. Zusätzlich ist in FIG 1 auch eine Ansteuerungseinheit 2, auch Treiberschaltung genannt, gezeigt, mit der die Leuchtdiodeneinheit 1 im regulären Betrieb angesteuert werden kann. Zwischen der Ansteuerungseinheit 2 und der Leuchtdiodeneinheit 1 verläuft eine Zuleitung ZL, über die im Normalbetrieb ein Strom $I_{Ext} = I_{Ext\_B}$ zu der Leuchtdiodeneinheit 1 fließt, mit dem die Leuchtdioden zum Leuchten gebracht werden. Wird dagegen ein Test der Leuchtdioden durchgeführt, so ist die Ansteuerungseinheit 2 abgeschaltet und der Strom von der Ansteuerungseinheit $I_{Ext\_B} = 0$ Ampere. Dafür wird bei dem Test die Testeinrichtung 3 zugeschaltet.

Die Testeinrichtung 3 umfasst eine Konstantstromquelle 4, welche einen Konstantstrom $I_{Test}$ als Teststrom erzeugt. Der Teststrom $I_{Test}$ teilt sich auf in einen ersten Ladestrom $I_{Test1}$ und einen zweiten Ladestrom $I_{Test2}$. Der erste Ladestrom $I_{Test1}$ dient der Ansteuerung der Leuchtdiodeneinheit 1 und fließt als externer Ladestrom $I_{Ext}$ über die Zuleitung zu der Leuchtdiodeneinheit 1. Der zweite Ladestrom $I_{Test2}$ dient dazu, eine interne Kapazität $C_{Ref}$ der Testeinrichtung 3 aufzuladen. Solang eine Durchlassspannung der Leuchtdioden der Leuchtdiodeneinheit 1 noch nicht erreicht wird, wird die Leitungskapazität der Zuleitung ZL weiter aufgeladen. Der in der Zuleitung ZL enthaltenen elektrischen Ladung entspricht eine elektrische Spannung $U_{Ext}$ der Zuleitung ZL. Für den Fall, dass die Leuchtdioden in Ordnung sind, liegt nach einem Aufladeprozess eine Durchlassspannung an den Leuchtdioden der Leuchtdiodeneinheit 1 an und die Spannung $U_{Ext}$ an der Zuleitung ZL bzw. der Leuchtdiodeneinheit 1 steigt nicht mehr weiter an. Dagegen steigt die Spannung $U_{Ref}$ an der internen Kapazität $C_{Ref}$ weiter an. Die beiden elektrischen Spannungen $U_{Ref}$, $U_{Ext}$ werden von einer Messeinheit 5 erfasst. An einem ersten Eingang 5a der Messeinheit 5 liegt die Referenzspannung $U_{Ref}$ an und an einem zweiten Eingang 5b liegt die externe Zuleitungsspannung $U_{Ext}$ an. Die Messeinheit 5 führt einen Vergleich zwischen den beiden Spannungen durch. Im einfachsten Fall, wird einfach eine Differenz der beiden elektrischen Spannungen ermittelt. Das Vergleichsergebnis wird über einen Ausgang 5c an eine Auswerteeinheit 6 übermittelt, welche daraus ermittelt, ob die Leuchtdiodeneinheit 1 in Ordnung ist. Liegt zum Beispiel eine ermittelte Spannungsdifferenz oberhalb eines vorbestimmten Schwellwertes, beispielsweise 0,7 V, so wird dieser Wert von der Auswerteeinheit 6 als Beleg dafür gewertet, dass die Leuchtdiodeneinheit 1 in Ordnung ist.

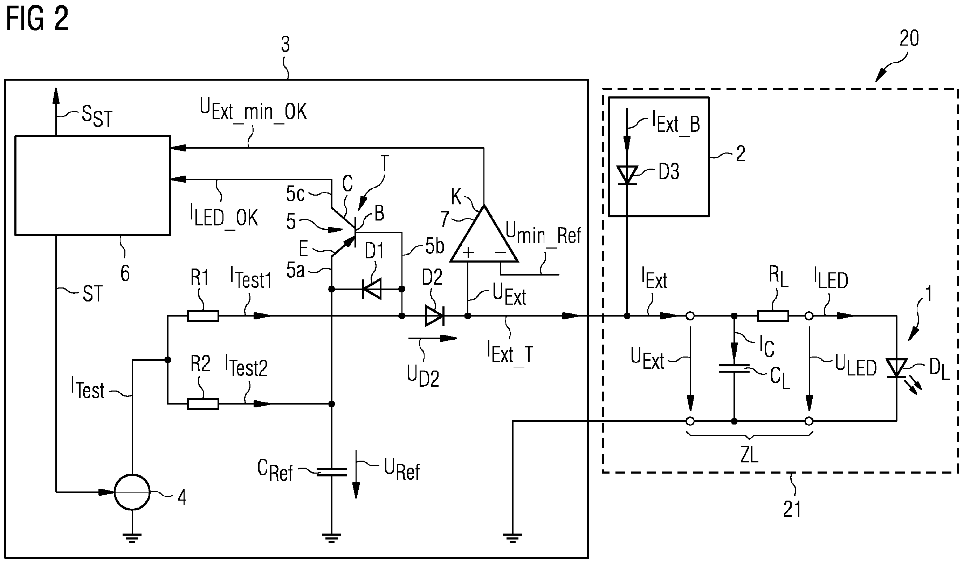

In FIG 2 ist ein Schaltplan einer Schaltungsanordnung 20 zur Ansteuerung und Überwachung von Leuchtdioden 1 einer Lichtzeichenanlage 21 gemäß einem Ausführungsbeispiel der Erfindung gezeigt. Die Lichtzeichenanlage 21 umfasst eine Leuchtdiodeneinheit 1, die Schaltungsanordnung 20 umfasst eine Ansteuerungseinheit 2, eine Testeinrichtung 3 sowie eine Zuleitung ZL zwischen der Ansteuerungseinheit 2 bzw. der Testeinrichtung 3 und der Leuchtdiodeneinheit 1. Die Leuchtdiodeneinheit 1 ist durch eine Leuchtdiode $D_L$ symbolisiert. Wie bereits erwähnt, kann eine solche Leuchtdiodeneinheit sowohl eine einzige als auch mehrere Leuchtdioden umfassen, die vorzugsweise in Reihe geschaltet sind. Wie bereits erwähnt, sind auch grundsätzlich Tests von Parallelschaltungen möglich, jedoch mit der ebenfalls bereits genannten Einschränkung, dass dann nur ermittelt werden kann, ob mindestens eine der parallelgeschalteten Leuchtdioden in Ordnung ist.

Durch die Leuchtdiodeneinheit 1 fließt im Normalbetrieb ein Leuchtdiodenstrom $I_{LED}$ und es fällt eine elektrische Spannung $U_{LED}$ an der Leuchtdiodeneinheit 1 ab. Die Ansteuerungseinheit 2, auch Treiberschaltung genannt, erzeugt im Normalbetrieb einen elektrischen Strom $I_{Ext} = I_{Ext\_B}$ in der Zuleitung ZL zwischen der Ansteuerungseinheit 2 und der Leuchtdiodeneinheit 1. Die Zuleitung ZL weist gegenüber einem Referenzpotential, z.B. Masse, eine Kapazität $C_L$ auf und als Leitungswiderstand einen ohmschen Widerstand $R_L$ auf. In der in FIG 2 gezeigten, der Anordnung aus Zuleitung und Leuchtdiodeneinheit entsprechenden Ersatzschaltung ist die Kapazität $C_L$ der Zuleitung ZL parallel zu einer Reihenschaltung aus dem Zuleitungswiderstand $R_L$ und der Leuchtdiodeneinheit 1 geschaltet. Insbesondere teilt sich der von der Treiberschaltung 2 erzeugte elektrische Strom $I_{Ext} = I_{Ext\_B}$ in einen Kondensatorstrom $I_C$ und einen Leuchtdiodenstrom $I_{LED}$ auf. Die Überwachung der Leuchtdiodeneinheit 1 kann nun zum Beispiel derart erfolgen, dass die Treiberschaltung 2 in bestimmten Zeitabständen kurz abgeschaltet wird, so dass der von der Treiberschaltung 2 erzeugte elektrische Strom $I_{Ext\_B}$ 0 Ampere beträgt. Stattdessen wird zur Überprüfung der Leuchtdiodeneinheit die bereits erwähnte Testeinrichtung 3 zugeschaltet.

Die Ansteuerungseinheit 2 kann auch eigene Messmittel für Spannung und Strom besitzen oder diese mit der Testeinrichtung teilen und kann dadurch die Funktionsfähigkeit der LED(s) selbst im eingeschalteten Zustand ermitteln. Wie bereits erwähnt, kann die Erkennung von LED-Kurzschlüssen bei großen LED-Strömen mit großen Zuleitungswiderstandswerten jedoch durch die Ansteuerungseinheit 2 nicht möglich sein, weswegen die Kurzschlusserkennung der LEDs dann durch die Testeinrichtung in Testintervallen zeitlich zwischen zwei Einschaltzuständen erfolgen muss.

Die Testeinrichtung 3 umfasst eine steuerbare Konstantstromquelle 4, welche angesteuert mit Hilfe eines Steuersignals ST, welches von einer Steuereinheit der Testeinrichtung ausgesandt wird, die zum Beispiel Teil einer Auswerteeinheit 6 sein kann, einen konstanten Teststrom $I_{Test}$ erzeugt. Der konstante Teststrom $I_{Test}$ wird in der Testeinrichtung 3 in zwei Teilströme $I_{Test1}$, $I_{Test2}$ aufgeteilt, deren Stärke bzw. Aufteilungsverhältnis durch einen ersten ohmschen Widerstand R1 und einen zweiten ohmschen Widerstand R2 festgelegt werden kann. Werden die Werte für die ohmschen Widerstände R1, R2 gleich groß gewählt, so sind auch die beiden Teilströme $I_{Test1}$, $I_{Test2}$ gleich stark. Ein erster Teilstrom $I_{Test1}$ dient als externer Teststrom bzw. als ein erster Ladestrom $I_{Ext\_T}$, mit dem bzw. dessen Anteil $I_C$ zunächst die Zuleitungskapazität $C_L$ der Zuleitung ZL aufgeladen wird, bis eine Durchlassspannung der Leuchtdiodeneinheit 1 erreicht ist. Exakt ausgedrückt, erhöht sich während des Aufladens der Kapazität $C_L$ der Zuleitung ZL die Ladespannung $U_{Ext}$ an der Kapazität $C_L$, bis die Ladespannung $U_{Ext}$ der Durchlassspannung der Leuchtdiodeneinheit entspricht, d.h., bis die Leuchtdioden der Leuchtdiodeneinheit leitend werden.

Parallel zu diesem Vorgang wird mit dem zweiten Teilstrom $I_{Test2}$ eine interne Referenzkapazität $C_{Ref}$ aufgeladen, an der eine dem jeweiligen Aufladezustand entsprechende Referenzspannung $U_{Ref}$ anliegt. Die Größe der internen Referenzkapazität $C_{Ref}$ ist sinnvollerweise so zu wählen, dass sie die Leitungskapazität $C_L$ bzw. eine Summe aus der Leitungskapazität und der Kapazität der Leuchtdioden übersteigt. Auf diese Weise ist nämlich bis zum Erreichen der Durchlassspannung der Leuchtdiodeneinheit die interne Referenzspannung $U_{Ref}$ niedriger als die an der Zuleitung ZL anliegende externe Spannung $U_{Ext}$. Werden nun nach dem Erreichen der Durchlassspannung der Leuchtdiodeneinheit deren Leuchtdioden leitend, so wird die Zuleitungskapazität $C_L$ nicht mehr weiter aufgeladen, d.h., die externe Spannung $U_{Ext}$ bleibt nun konstant, während sich die interne Referenzspannung $U_{Ref}$ an der internen Referenzkapazität $C_{Ref}$ weiter auflädt. Aus diesem Grund übersteigt nun der Wert der internen Referenzspannung $U_{Ref}$ den Wert der externen Spannung $U_{Ext}$. Dieses Verhalten wird von der Testeinrichtung 3 mit Hilfe einer Messeinheit 5 detektiert.

Die Messeinheit 5 umfasst einen ersten Eingang 5a und einen zweiten Eingang 5b. Der erste Eingang 5a ist mit der internen Referenzkapazität $C_{Ref}$ elektrisch verbunden, so dass am ersten Eingang 5a die interne Referenzspannung $U_{Ref}$ anliegt. Der zweite Eingang 5b der Messeinheit 5 ist über die Entkopplungsdiode D2 mit der Zuleitung ZL elektrisch verbunden, so dass an dem zweiten Eingang 5b der Messeinheit die externe Spannung $U_{Ext}$ abzüglich der Diodenspannung von D2 anliegt. In dem in FIG 2 gezeigten konkreten Ausführungsbeispiel umfasst die Messeinheit 5 einen Bipolartransistor T, dessen Emitter E mit dem ersten Eingang 5a verbunden ist. Weiterhin ist die Basis B des Bipolartransistors T mit dem zweiten Eingang 5b verbunden. Überdies umfasst der Bipolartransistor T auch einen Kollektor C, welcher mit einem Ausgang 5c der Messeinheit 5 verbunden ist. Liegt nun im Testbetrieb nach dem Durchschalten der Leuchtdiodeneinheit 1 an dem ersten Eingang, und damit an dem Emitter E, eine um einen vorbestimmten Wert, beispielsweise 0,7 Volt, höhere elektrische Spannung $U_{Ref}$ an als die Spannung $U_{Ext}$ abzüglich der Diodenspannung der zweiten Diode D2 an dem zweiten Eingang 5b und damit an der Basis B, so schaltet der Transistor T durch und es fließt ein Strom $I_{LED\_OK}$ von der Messeinheit 5 zu einer Auswerteeinheit 6, welcher signalisiert, dass die Leuchtdiodeneinheit 1 korrekt funktioniert. D.h., die LEDs der Leuchtdiodeneinheit 1 werden von der Auswerteeinheit 6 als durchgängig eingestuft und es ist davon auszugehen, dass keine Unterbrechung in der LED-Kette der Leuchtdiodeneinheit 1 vorhanden ist. Es soll in diesem Zusammenhang noch angemerkt werden, dass der Einsatz eines Feldeffekttransistors T nur eine von vielen Ausführungsformen für eine Messeinheit 5 darstellt. Eine solche Messeinheit kann alternativ oder zusätzlich auch andere Arten von Schaltern, beispielsweise Feldeffekttransistoren, Relais, Röhrenschaltungen oder auch komplexere analoge oder digitale elektronische Schaltungen umfassen. Beispielsweise kann eine Messeinheit 5 eine Komparatorschaltung umfassen, welche die beiden Ladespannungen $U_{Ref}$, $U_{Ext}$ vergleicht und für den Fall, dass die an der Referenzkapazität $C_{Ref}$ abfallende Spannung $U_{Ref}$ einen größeren Wert aufweist als die externe Spannung $U_{Ext}$, ein Signal ausgibt, welches anzeigt, dass die Leuchtdioden funktionsfähig sind.

Wird von der Auswerteeinheit 6 ermittelt, dass die Leuchtdiodeneinheit 1 in Ordnung ist, so wird sofort an die Konstantstromquelle 4 ein Steuersignal ST übermittelt, mit dem die Konstantstromquelle 4 abgeschaltet wird. Auf diese Weise wird verhindert, dass im Testbetrieb ein unerwünschtes Aufleuchten der Leuchtdiodeneinheit 1 erfolgt. Anschließend kann der reguläre Betrieb der Leuchtdiodeneinheit 1 durch Ansteuern über die Treiberschaltung 2 wieder aufgenommen. Die Testläufe können während des normalen Betriebs periodisch in bestimmten Zeitintervallen erfolgen. Beispielsweise kann nach einer Sekunde Normalbetrieb ein solcher Testlauf zwischengeschaltet werden, der selbst nur sehr kurze Zeit, beispielsweise 10 μs benötigt. Wird innerhalb dieser Maximalzeit von 10 μs keine Bestätigung der Funktion der Leuchtdiodeneinheit 1 erhalten, so wird die Konstantstromquelle 4 trotzdem ausgeschaltet und der Testvorgang mit einem negativen Ergebnis beendet. Anschließend erfolgt eine Meldung an eine Überwachungs- und Wartungseinrichtung (nicht gezeigt), dass in der überwachten Leuchtdiodeneinheit 1 ein Defekt vorliegt. Im Vergleich zu der Betriebszeit der Leuchtdiodeneinheit 1 ist die Testphase so kurz, dass sie von Verkehrsteilnehmern auch für den Fall von leuchtenden Leuchtdiodeneinheiten nicht wahrgenommen wird. Durch das sofortige Abschalten der Konstantstromquelle 4 mit dem Erreichen der Durchlassspannung der Leuchtdiodeneinheit 1 wird verhindert, dass in den Leuchtdioden der Leuchtdiodeneinheit 1 ein signifikanter Stromfluss auftritt, so dass ein unerwünschtes sichtbares Aufleuchten der Leuchtdioden während des Tests vermieden wird.

Damit auch ein interner Kurzschluss der Leuchtdioden 1 erkannt wird, bei dem zwar die Leuchtdioden 1 einen LED-Strom $I_{LED}$ durchfließen lassen, aber aufgrund des internen Kurzschlusses nicht leuchten können, wird zusätzlich die an der Leuchtdiodeneinheit 1 abfallende elektrische Spannung $U_{LED}$ überwacht. Dies wird mit Hilfe einer Kurzschlussermittlungsschaltung 7 erreicht. Die Kurzschlussermittlungsschaltung 7 umfasst in der in FIG 2 gezeigten konkreten Ausführungsform einen Komparator K, an dessen mit "+" gekennzeichneten nichtinvertierten Eingang die im Wesentlichen der Leuchtdiodenspannung $U_{LED}$ entsprechende externe Spannung $U_{Ext}$ anliegt. An einem mit "-" gekennzeichneten invertierten Eingang des Komparators K liegt eine Mindestspannung $U_{min\_Ref}$ als Referenzspannung an, welche ein Kriterium dafür liefert, ob in der Leuchtdiodeneinheit 1 ein Kurzschluss vorliegt oder nicht.

Wird die genannte Mindestspannung $U_{min\_Ref}$ durch die externe Spannung $U_{Ext}$ übertroffen, so kann davon ausgegangen werden, dass die vorab festgelegten Mindestanforderungen an die Kurzschlussfreiheit der Leuchtdiodeneinheit 1 erfüllt sind. Für diesen Fall übermittelt die Kurzschlussermittlungseinheit 7 ein positives Spannungssignal $U_{Ext\_min\_OK}$ an die Auswerteeinheit 6, welches die Auswerteeinheit als Bestätigung für eine Erfüllung der Mindestanforderungen an die Kurzschlussfreiheit der Leuchtdiodeneinheit interpretiert. Für den Fall, dass von der externen Spannung $U_{Ext}$ die Referenzspannung $U_{min\_Ref}$ nicht überschritten wird, liegt am Ausgang des Komparators K der Kurzschlussermittlungsschaltung 7 ein negatives Signal an, welches die Auswerteeinheit 6 empfängt und als Indikator für einen Kurzschluss in der Leuchtdiodeneinheit 1 auffasst. Je nach Wahl der Referenzspannung $U_{min\_Ref}$ kann festgelegt werden, bei welcher Anzahl von kurzgeschlossenen Leuchtdioden die Leuchtdiodeneinheit noch als funktionsfähig oder bereits als defekt eingestuft werden soll. Wird die Kurzschlussermittlungsschaltung zumindest teilweise in Form einer Software ausgestaltet, so kann die Referenzspannung $U_{min\_Ref}$ für den jeweiligen Anwendungsfall individuell eingestellt werden, ohne dass an der Hardware etwas geändert werden muss.

Insgesamt erhält die Auswerteeinheit 6 bei dieser speziellen Ausführungsform zwei Signale $U_{Ext\_min\_OK}$, $I_{LED\_OK}$ und ermittelt, dass die Leuchtdiodeneinheit 1 korrekt funktioniert, wenn zusätzlich zu dem Signal $I_{LED\_OK}$ von der Messeinheit 5 auch ein positives Signal $U_{Ext\_min\_OK}$ von der Kurzschlussermittlungseinheit 7 empfangen wurde. Fehlt eines der beiden Signale bzw. ist das Signal von der Kurzschlussermittlungseinheit 7 negativ, so gibt die Auswerteeinheit 6 ein negatives Statussignal $S_{ST}$ aus, welches einen Defekt der Leuchtdiodeneinheit 1 signalisiert. Das Statussignal $S_{ST}$ kann den vorhandenen Defekt dahingehend spezifizieren, dass es angibt, ob ein Kurzschluss in der Leuchtdiodeneinheit 1 vorliegt oder ob der Stromdurchfluss der Leuchtdioden nicht funktioniert. Andernfalls gibt die Auswerteeinheit 6 ein positives Statussignal $S_{ST}$ aus, mit dem die korrekte Funktion der getesteten Leuchtdiodeneinheit 1 bestätigt wird.

Zusätzlich umfasst die Testeinrichtung 3 in dem in FIG 2 gezeigten konkreten Ausführungsbeispiel noch eine erste Diode D1, welche für kleine Zuleitungskapazitäten $C_L$ den Testablauf optimiert. In diesem Fall wird mit Hilfe der ersten Diode D1 dafür gesorgt, dass ein LED-Lichtzeichen durch den Testbetrieb nicht zu stark aufleuchtet, indem der Teststrom $I_{Test1}$, der über den ersten ohmschen Widerstand R1 fließt, dann teilweise direkt über die erste Diode D1 auf die interne Kapazität geführt wird und diese noch schneller auflädt. Dadurch wird die Referenzkapazität $C_{Ref}$ schneller aufgeladen, was zu einer Verkürzung der Testzeit und damit eine Verkürzung einer eventuellen Aufleuchtzeit der Leuchtdioden der Leuchtdiodeneinheit 1 führt. Die erste Diode D1 ist zwischen den zweiten Eingang 5b und den ersten Eingang 5a der Messeinheit 5 geschaltet.

Weiterhin umfasst die in FIG 2 gezeigte Testeinrichtung 3 noch eine zweite Diode D2, welche zwischen den ersten ohmschen Widerstand R1 und den Ausgang der Testeinrichtung 3 geschaltet ist und an der im Durchlassfall eine elektrische Spannung $U_{D2}$ abfällt. Die zweite Diode D2 entkoppelt die Testeinrichtung 3 von der Ansteuerungseinheit 2. Auf diese Weise wird erreicht, dass in der normalen Betriebsphase der Leuchtdiodeneinheit 1 kein Strom von der Ansteuerungseinheit 2 in die Testeinrichtung 3 fließt und fälschlicherweise als Betriebsstrom des LED-Lichtzeichens interpretiert wird.

Die zweite Diode D2 kann alternativ auch zwischen dem Eingang "+" der Kurzschlussermittlungsschaltung 7 und dem Ausgang der Testeinrichtung 3 liegen, wenn die Kurzschlussermittlungsschaltung 7 nicht durch die Ansteuerungseinheit 2 auch mitverwendet werden soll.

Überdies umfasst die in FIG 2 gezeigte Lichtzeichenanlage 20 noch eine dritte Diode D3. Diese ist in die Ansteuerungseinheit 2 integriert. Die dritte Diode D3 dient ebenfalls der Entkopplung zwischen der Testeinrichtung 3 und der Ansteuerungseinheit 2. Mit der dritten Diode D3 soll sichergestellt werden, dass die Testeinrichtung 3, die nur bei ausgeschalteter Leuchtdiodeneinheit 1 kurzzeitig aktiviert ist, nicht durch die Ansteuerungseinheit 2, die nur für das betriebsbedingte Ansteuern der Leuchtdiodeneinheit 1 während einer Phase des normalen Betriebs aktiviert ist, beeinflusst wird.

Der Zuleitungswiderstand $R_L$ der Zuleitung ZL, der typischerweise einige Ohm beträgt, kann im Regelfall für das beschriebene Testverfahren unberücksichtigt bleiben, da hierbei typischerweise mit Ladeströmen im Bereich bis zu einigen mA gearbeitet wird, deren Spannungsabfälle an dem Zuleitungswiderstand $R_L$ vernachlässigt werden können.

Statt einer einzigen Konstantstromquelle 4, deren Strom $I_{Test}$ durch die beiden ohmschen Widerstände R1, R2 aufgeteilt wird, können alternativ auch zwei verschiedene steuerbare Konstantstromquellen verwendet werden, wobei die erste Konstantstromquelle die externe Zuleitungskapazität $C_L$ auflädt und die zweite Konstantstromquelle die interne Referenzkapazität $C_{Ref}$ der Testeinrichtung auflädt.

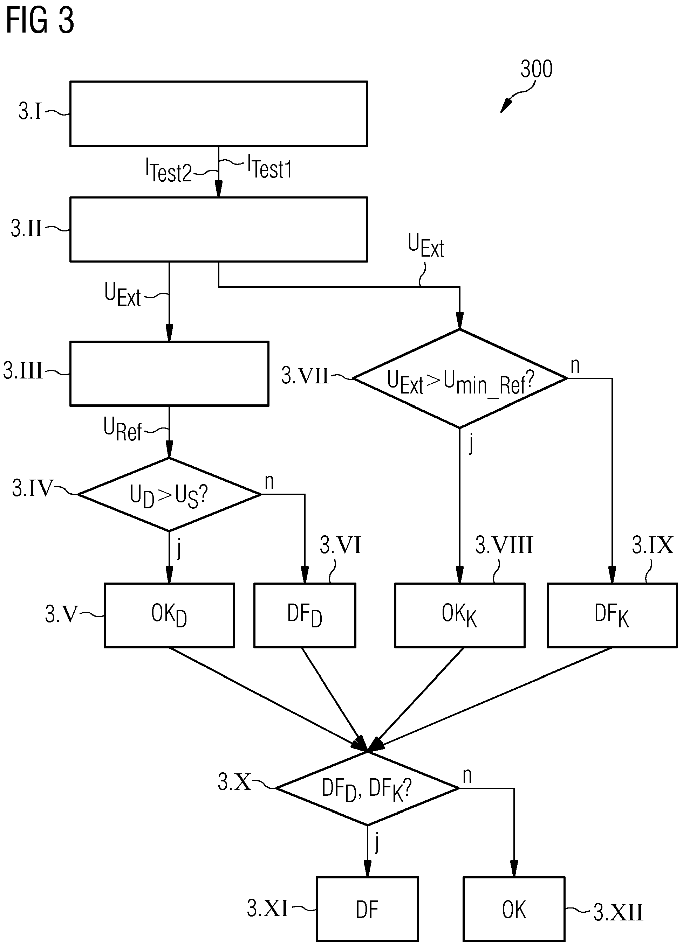

In FIG 3 ist ein Flussdiagramm 300 gezeigt, welches ein Verfahren zum Überwachen der Funktion einer Leuchtdiodeneinheit 1 gemäß einem Ausführungsbeispiel der Erfindung veranschaulicht. Im Rahmen des Testverfahrens wird zunächst bei einem Schritt 3. I ein erster Konstantstrom $I_{Test1}$ erzeugt, welcher durch eine Zuleitung ZL der Leuchtdiodeneinheit 1 fließt. Solange eine für die Leuchtdioden der Leuchtdiodeneinheit charakteristische Durchlassspannung nicht erreicht wurde, wird die Zuleitung gegen ein Bezugspotential, insbesondere Masse, immer weiter aufgeladen, so dass eine externe Ladespannung $U_{Ext}$ zwischen der Zuleitung ZL und einem Bezugspotential entsteht. Die an der Zuleitung ZL anliegende elektrische Ladespannung $U_{Ext}$ steigt an, bis die genannte Durchlassspannung der Leuchtdiodeneinheit 1 erreicht ist. Anschließend schalten bei korrekter Funktion die Leuchtdioden durch und die externe Ladespannung $U_{Ext}$ steigt nicht weiter an. Gleichzeitig wird bei dem Schritt 3.I auch ein zweiter Konstantstrom $I_{Test2}$ an eine Referenzkapazität $C_{Ref}$ angelegt und die Referenzkapazität $C_{Ref}$ wird zeitgleich mit der Zuleitung ZL aufgeladen, so dass an der Referenzkapazität $C_{Ref}$ eine interne Ladespannung $U_{Ref}$ auftritt.

Weiterhin wird bei einem Schritt 3.II die an der Zuleitung ZL anliegende externe elektrische Ladespannung $U_{Ext}$ mit Hilfe einer Messeinheit gemessen. Zusätzlich wird bei einem Schritt 3.III die an der Referenzkapazität $C_{Ref}$ anliegende interne elektrische Ladespannung $U_{Ref}$ gemessen. Da bei korrekter Funktion der Dioden der Leuchtdiodeneinheit die externe elektrische Ladespannung $U_{Ext}$ einen bestimmten Wert nicht überschreitet und die interne elektrische Ladespannung $U_{Ref}$ weiter ansteigt, ist bei korrekter Funktion der Dioden zu erwarten, dass die interne Ladespannung die externe Ladespannung kurz nach dem Erreichen der Durchlassspannung der Leuchtdioden übersteigt und anschließend sich eine Differenz zwischen den beiden Ladespannungen ausbildet.

Bei einem Schritt 3.IV wird ein Vergleich zwischen der externen elektrischen Ladespannung $U_{Ext}$ und der internen elektrischen Ladespannung $U_{Ref}$ vorgenommen. Dieser Vergleich kann zum Beispiel mit Hilfe eines Transistors oder einer Komparatorschaltung erfolgen. Wird bei dem Schritt 3.IV ermittelt, dass die Differenz $U_D$ zwischen der internen elektrische Ladespannung $U_{Ref}$ und der externen Ladespannung $U_{Ext}$ größer ist als ein vorbestimmter Schwellwert Us, welcher beispielsweise 0,7 V beträgt, was in FIG 3 mit "j" gekennzeichnet ist, so wird zu dem Schritt 3.V übergegangen und eine Durchgängigkeit $OK_D$ der Leuchtdiodeneinheit 1 wird bei dem Schritt 3.V festgestellt. Wird bei dem Schritt 3.IV nach einer Maximalzeit, beispielsweise 10 $\mu$s, immer noch festgestellt, dass die Differenz $U_D$ zwischen der internen elektrischen Ladespannung $U_{Ref}$ und der externen Ladespannung $U_{Ref}$ nicht größer ist als ein vorbestimmter Schwellwert Us, was in FIG 3 mit "n" gekennzeichnet ist, so wird zu dem Schritt 3.VI übergegangen und ein Unterbrechungsdefekt $DF_D$ der Leuchtdiodeneinheit 1 festgestellt.

Bei einem Schritt 3.VII wird ermittelt, ob ein Wert einer an der Leuchtdiodeneinheit 1 abfallenden elektrischen Spannung $U_{Ext}$ einen Mindestspannungswert $U_{min\_Ref}$ übersteigt. Der Wert der an der Leuchtdiodeneinheit 1 abfallenden elektrischen Spannung $U_{Ext}$ kann insbesondere den Wert der bei dem Schritt 3.II ermittelten elektrischen Ladespannung $U_{Ext}$ umfassen. Übersteigt der ermittelte Spannungswert $U_{Ext}$ den Mindestspannungswert $U_{min\_Ref}$, was in FIG 3 mit "j" gekennzeichnet ist, so wird bei dem Schritt 3.VIII festgestellt, dass in der Leuchtdiodeneinheit 1 kein Kurzschlussdefekt vorliegt, was in FIG 3 mit "$OK_K$" gekennzeichnet ist. Übersteigt der ermittelte Spannungswert $U_{Ext}$ den Mindestspannungswert $U_{min\_Ref}$ nach einer Maximalzeit, beispielsweise 10 $\mu$s, nicht, was in FIG 3 mit "n" gekennzeichnet ist, so wird bei dem Schritt 3.IX festgestellt, dass ein Kurzschlussdefekt $DF_K$ in der Leuchtdiodeneinheit 1 vorliegt. Schließlich wird bei dem Schritt 3.X in Abhängigkeit von den Ermittlungsergebnissen bei den Schritten 3.V bzw. 3.VI und bei den Schritten 3.VIII bzw. 3.IX ermittelt, ob die Leuchtdiodeneinheit korrekt funktioniert. Wurde bei einem der Schritte 3.VI und 3.IX ein Defekt der Leuchtdiodeneinheit festgestellt, was in FIG 3 an dem Pfeil zwischen den Schritten 3.X und 3.XI mit "j" gekennzeichnet ist, so wird bei dem Schritt 3.XI eine Fehlermeldung ausgegeben, welche die Information eines Defekts DF der Leuchtdiodeneinheit umfasst. Wird bei dem Schritt 3.X ermittelt, dass kein Defekt vorliegt, d.h., dass insbesondere bei den Schritten 3.V und 3.VIII festgestellt wurde, dass kein Defekt in Form einer mangelnden Durchgängigkeit oder in Form eines Kurzschlusses vorliegt, so wird bei dem Schritt 3.XII eine Meldung OK darüber ausgegeben, dass die Leuchtdiodeneinheit 1 korrekt funktioniert.

Mit Hilfe der beschriebenen Testanordnung und dem beschriebenen Testverfahren ist es auch möglich, LED-Lichtzeichen im ausgeschalteten Zustand zu überwachen, ohne dass ein signifikanter Stromfluss durch die Leuchtdioden auftritt, der zu einem sichtbares Aufblitzen der Leuchtdioden führen könnte und zum Beispiel Verkehrsteilnehmer irritieren könnte. Mithin wird das unerwünschte Aufleuchten der Leuchtdioden während des Tests im Vergleich zu herkömmlichen Testverfahren stark reduziert. Statt einer Strommessung, wie bei herkömmlichen Verfahren, werden unter Zuhilfenahme einer Konstantstromquelle Ladespannungen $U_{Ext}$, $U_{Ref}$ an der Zuleitungskapazität $C_L$ und an einer internen Referenzkapazität $C_{Ref}$ gemessen und verglichen. Bei dem Erreichen einer Durchlassspannung der Leuchtdioden wird die Konstantstromquelle sofort abgeschaltet, ohne dass bereits ein signifikanter Stromfluss aufgetreten ist. Dadurch wird das bei herkömmlichen Testverfahren auftretende unerwünschte Aufleuchten der Leuchtdioden während des Tests erheblich reduziert.

Zudem können auch Lichtzeichen im ausgeschalteten Zustand korrekt überwacht werden, wenn diese über längere Zuleitungen an LED-Treiberschaltungen angeschlossen sind, was bei herkömmlichen Überwachungsverfahren nur mit einer Erhöhung der Stärke der Teststromimpulse erreicht wird, wodurch allerdings ein unerwünschtes und irritierendes Aufblitzen der Leuchtdioden in Kauf genommen werden muss. Somit lassen sich bei Anwendung des erfindungsgemäßen Testverfahrens auch LED-Lichtzeichen überwachen, die über längere Zuleitungen an LED-Treiberschaltungen angeschlossen sind, was in vielen Fällen den Aufbau bzw. die technische Realisierung einer solchen Anlage vereinfacht und damit auch kostengünstiger macht. Mit der erzielten Reduktion des Aufblitzens der Leuchtdioden im Testbetrieb lässt sich das Einsatzfeld erweitern, insbesondere auf solche Fälle, in denen ein solches ungewolltes Aufblitzen der Leuchtdioden eine Gefährdung der Sicherheit von Verkehrsteilnehmern darstellt.

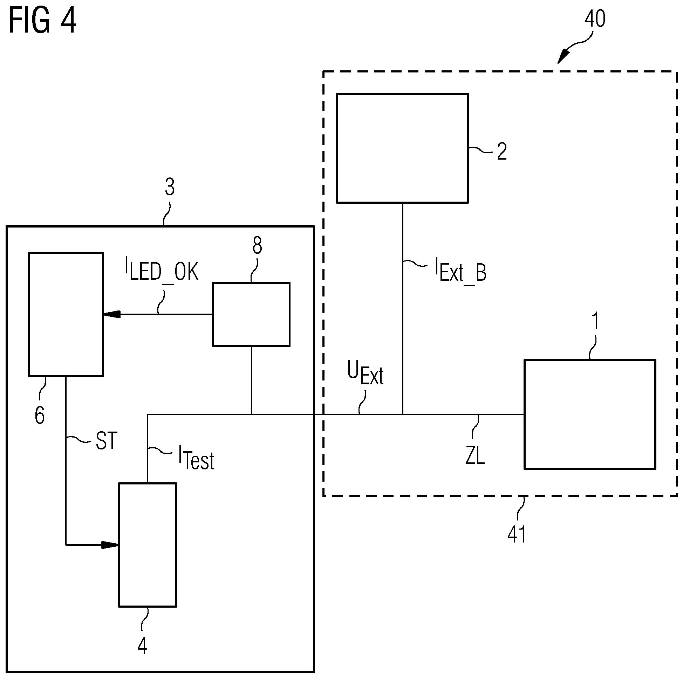

In FIG 4 ist eine alternative Ausführungsform einer Schaltungsanordnung 40 zur Ansteuerung und Überwachung von Leuchtdioden einer Lichtzeichenanlage 41 gezeigt. Bei der alternativen Ausführungsform entfallen die Referenzkapazität $C_{Ref}$, der zweite ohmsche Widerstand R2 und optional der erste ohmsche Widerstand R1, der Transistor T und die erste Diode D1 in der Testeinrichtung 3. Statt des Vergleichs mit der Ladespannung $U_{Ref}$ der Referenzkapazität $C_{Ref}$ wird bei der in FIG 4 gezeigten Ausführungsform beim Laden der externen Zuleitungskapazität $C_L$ der Zuleitung $Z_L$ die Ladespannung $U_{Ext}$ mit Hilfe einer Spannungsüberwachungseinrichtung 8 permanent gemessen und überwacht. Wird ermittelt, dass die externe Ladespannung $U_{Ext}$ nicht mehr zunimmt, so wird dies als Zeichen einer korrekten Funktion der Leuchtdioden interpretiert. Dieser Sachverhalt kann zum Beispiel durch Ermitteln der zeitlichen Ableitung der Ladespannung $U_{Ext}$ und Vergleichen mit einem vorbestimmten Vergleichswert $dU/dt_{Ref}$ einer zeitlichen Ableitung detektiert werden. Der vorbestimmte Vergleichswert kann zum Beispiel den Wert 0 aufweisen. Auf diese Weise wird detektiert, dass an den Leuchtdioden der Leuchtdiodeneinheit 1 eine Durchlassspannung anliegt, bei der die Leuchtdioden durchschalten. Wird von der Spannungsüberwachungseinrichtung 8 ermittelt, dass die Durchlassspannung erreicht ist, so wird an die Auswerteeinrichtung 6 ein Signal $I_{LED\_OK}$ gegeben, welches die Information umfasst, dass die Leuchtdioden durchschalten. Die Auswerteeinrichtung 6 zieht daraus den Schluss, dass die Leuchtdioden der Leuchtdiodeneinheit 1 in Ordnung sind und gibt umgehend einen Befehl ST an die Stromquelle 4, die Stromerzeugung einzustellen. Weiterhin kann mit der Spannungsüberwachungseinrichtung 8 auch ein Kurzschluss detektiert werden, indem die Ladespannung $U_{Ext}$ mit einer Mindestspannung analog zu der in FIG 2 gezeigten Ausführungsform verglichen wird.

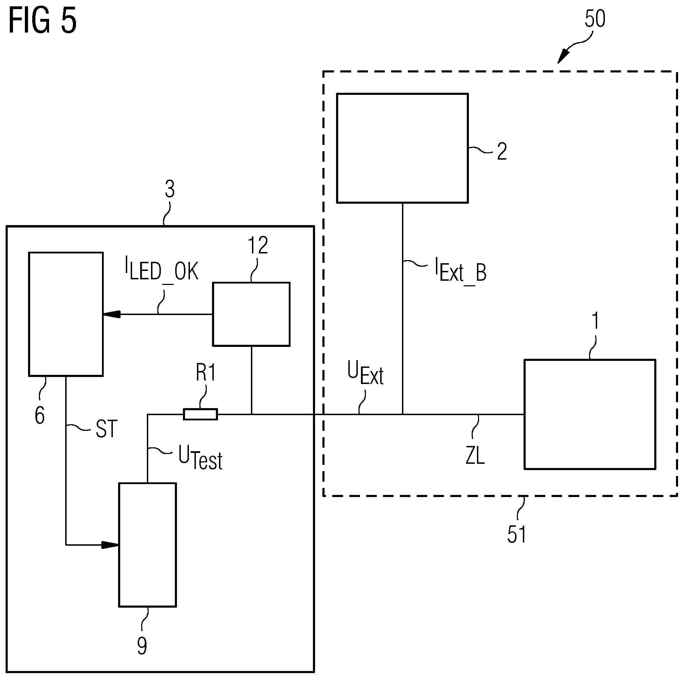

In FIG 5 ist noch eine andere alternative Ausführungsform einer Schaltungsanordnung 50 zur Ansteuerung und Überwachung von Leuchtdioden einer Lichtzeichenanlage 51 gezeigt. Bei dieser Variante wird im Vergleich zu der in FIG 4 gezeigten Variante statt einer Stromquelle 4 eine Spannungsquelle 9 mit kleinem Strom, deren Spannung $U_{Test}$ variabel ist und bei dem Funktionstest langsam hochgefahren wird, zum Erzeugen der externen Ladespannung $U_{Ext}$ verwendet. Ein Vorwiderstand R1 dient bei dieser Variante dazu, im Durchlassfall einen zu starken Strom zu verhindern. Eine Spannungsmesseinrichtung 12 misst die externe Ladespannung $U_{Ext}$. Solange kein Strom durch die Leuchtdioden der Leuchtdiodeneinheit 1 fließt, entspricht die externe Ladespannung $U_{Ext}$ der Spannung $U_{Test}$ der Spannungsquelle 9. Beginnt ein Strom durch die Leuchtdioden zu fließen, so fällt an dem Vorwiderstand R1 eine elektrische Spannung ab und die Spannungsänderung $\Delta U$ wird von der Spannungsmesseinrichtung 12 detektiert. In diesem Fall muss die Spannungsquelle 9 sofort abgeschaltet werden, um einen stärkeren Stromfluss durch die Leuchtdioden zu verhindern. Hierfür gibt die Spannungsmesseinrichtung 12 eine Meldung $I_{LED\_OK}$ an die Auswerteeinrichtung 6 aus, welche diese über die korrekte Funktion der Leuchtdiodeneinheit 1 informiert. Die Auswerteeinrichtung gibt nun zusätzlich einen Steuerbefehl ST an die variable Spannungsquelle 9 aus, die Spannungserzeugung sofort zu stoppen. Zudem kann mit der Spannungsmesseinrichtung 12 auch ein Kurzschluss detektiert werden, indem die Ladespannung $U_{Ext}$ mit einer Mindestspannung analog zu der in FIG 2 gezeigten Ausführungsform verglichen wird.

Die in FIG 4 und 5 gezeigte Spannungsüberwachungseinrichtung 8 bzw. Spannungsmesseinrichtung 12 können in Form von fest verdrahten Schaltungen z.B. mit Hilfe von Transistoren und Operationsverstärkern realisiert sein. Sie können auch als Kombination aus Hardware und Software realisiert sein. Beispielsweise können die genannten Einheiten 8, 12 einen Mikroprozessor oder Kontroller umfassen, welcher mit einem für die jeweilige Aufgabe konzipierten Computerprogramm betrieben werden.

Es wird abschließend noch einmal darauf hingewiesen, dass es sich bei dem vorbeschriebenen Verfahren und der beschriebenen Schaltungsanordnungen 10, 20, 40, 50 lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

**Patentansprüche**

1. Verfahren zum Überwachen der Funktion einer Leuchtdiodeneinheit (1), aufweisend die Schritte:

   - Anlegen eines ersten Konstantstroms ($I_{Test}$, $I_{Test1}$) an eine Zuleitung (ZL) der Leuchtdiodeneinheit (1) zum Aufladen einer von der Zuleitung (ZL) und der Leuchtdiodeneinheit (1) gebildeten Kapazität durch den ersten Konstantstrom ($I_{Test}$, $I_{Test1}$),
   - Ermitteln einer an der Zuleitung (ZL) anliegenden externen elektrischen Ladespannung ($U_{Ext}$) während des Ladevorgangs, **gekennzeichnet durch**:

      - Durchführen eines Vergleichs auf Basis einer zeitlichen Ableitung der ermittelten externen elektrischen Ladespannung ($U_{Ext}$) und eines Referenzwerts ($U_{Ref}$, $dU/dt_{Ref}$),
      - Ermitteln einer korrekten Funktion der Leuchtdiodeneinheit (1) in Abhängigkeit von dem Vergleichsergebnis, wobei eine korrekte Funktion der Leuchtdiodeneinheit (1) ermittelt wird, wenn während des Ladevorgangs anhand des Vergleichsergebnisses ermittelt wurde, dass sich die extern anliegende elektrische Ladespannung ($U_{Ext}$) nicht weiter erhöht,
      - sofortiger Abbruch des Ladevorgangs nach dem Ermitteln der korrekten Funktion, sodass kein signifikanter elektrischer Strom, welcher eine Leuchtwirkung aufweist, die von dem menschlichen Auge wahrgenommen werden kann, durch die Leuchtdioden der Leuchtdiodeneinheit (1) fließt.

2. Verfahren nach Anspruch 1, aufweisend die Schritte:

   - Anlegen eines zweiten Konstantstroms ($I_{Test2}$) an eine Referenzkapazität ($C_{Ref}$),
   - Ermitteln einer an der Referenzkapazität ($C_{Ref}$) anliegenden internen elektrischen Ladespannung ($U_{Ref}$) als Referenzwert ($U_{Ref}$).

3. Verfahren nach Anspruch 2, wobei bei dem Vergleichsschritt eine Spannungsdifferenz ($U_D$) zwischen der externen elektrischen Ladespannung ($U_{Ext}$) und der internen elektrischen Ladespannung ($U_{Ref}$) ermittelt wird.

4. Verfahren nach Anspruch 3, wobei das Ermitteln einer korrekten Funktion einen Vergleich der ermittelten Spannungsdifferenz ($U_D$) mit einem vorbestimmten Schwellwert ($U_s$) umfasst.

5. Verfahren nach Anspruch 4, wobei eine den ersten ($I_{Test1}$) und/oder den zweiten Konstantstrom ($I_{Test2}$) erzeugende Konstantstromquelle (4) abgeschaltet wird, wenn die ermittelte Spannungsdifferenz ($U_D$) den vorbestimmten Schwellwert (Us) erreicht hat.

6. Verfahren nach einem der Ansprüche 2 bis 5, wobei die Leitungskapazität ($C_L$) nach Erreichen einer Durchlassspannung ($U_{DL}$) der Leuchtdiodeneinheit (1) aufgrund des einsetzenden Stromflusses ($I_{LED}$) durch Leuchtdioden ($D_L$) der Leuchtdiodeneinheit (1) nicht weiter aufgeladen wird und gleichzeitig eine interne Referenzkapazität ($C_{Ref}$) durch den zweiten Konstantstrom ($I_{Test2}$) weiter aufgeladen wird, sodass die zu ermittelnde Spannungsdifferenz ($U_D$) zwischen der externen elektrischen Ladespannung ($U_{Ext}$) und einer internen elektrischen Ladespannung ($U_{Ref}$) entsteht.

7. Verfahren nach Anspruch 5 oder 6, wobei ein Abschalten der Konstantstromquelle (4) erfolgt, bevor ein signifikanter Stromfluss durch die Leuchtdioden ($D_L$) der Leuchtdiodeneinheit (1) entsteht.

8. Verfahren nach einem der Ansprüche 4 bis 7, wobei für den Fall, dass nach einem vorbestimmten Zeitintervall keine Überschreitung des vorbestimmten Schwellwerts ($U_S$) durch die ermittelte Spannungsdifferenz ($U_D$) ermittelt wurde, ein Defekt der Leuchtdiodeneinheit (1) festgestellt wird.

9. Verfahren nach einem der Ansprüche 1 bis 8, wobei

- ein Wert einer an der Leuchtdiodeneinheit (1) abfallenden elektrischen Spannung ($U_{LED}$) ermittelt wird,
- der ermittelte Spannungswert ($U_{LED}$) mit einem Mindestspannungswert ($U_{min\_Ref}$) verglichen wird und
- in Abhängigkeit von dem Vergleich zwischen dem ermittelten Spannungswert ($U_{LED}$) und dem Mindestspannungswert ($U_{min\_Ref}$) ermittelt wird, ob in der Leuchtdiodeneinheit (1) ein elektrischer Kurzschluss vorliegt oder nicht.

10. Verfahren nach einem der Ansprüche 4 bis 8 und Anspruch 9, wobei für den Fall, dass ermittelt wird, dass nach einem vorbestimmten Zeitintervall entweder der vorbestimmte Schwellwert (Us) durch die ermittelte Spannungsdifferenz ($U_D$) nicht erreicht wurde oder ein Wert der an der Leuchtdiodeneinheit (1) abfallenden elektrischen Spannung ($U_{LED}$) den vorbestimmten Mindestspannungswert ($U_{min\_Ref}$) nicht erreicht hat, ein Defekt der Leuchtdiodeneinheit (1) festgestellt wird.

11. Testeinrichtung (3) zur Überwachung einer Leuchtdiodeneinheit (1), aufweisend:

- zumindest eine Konstantstromquelle (4) zum Anlegen eines ersten Konstantstroms ($I_{Test}$, $I_{Test1}$) an eine Zuleitung (ZL) der Leuchtdiodeneinheit (1) zum Aufladen einer von der Zuleitung (ZL) und der Leuchtdiodeneinheit (1) gebildeten Kapazität durch den ersten Konstantstrom ($I_{Test}$, $I_{Test1}$),
- eine Messeinheit (5)

- mit einem Eingang, an dem eine an der Zuleitung (ZL) der Leuchtdiodeneinheit (1) abfallende externe elektrische Ladespannung ($U_{Ext}$) während des Ladevorgangs anliegt, **gekennzeichnet durch**:
- mit einer Spannungsvergleichseinheit (T) zum Durchführen eines Spannungsvergleichs auf Basis einer zeitlichen Ableitung der externen elektrischen Ladespannung ($U_{Ext}$) und eines Referenzwerts ($U_{Ref}$, $dU/dt_{Ref}$),

- eine Auswerteeinheit (6) zum Ermitteln einer korrekten Funktion der Leuchtdiodeneinheit (1) in Abhängigkeit von dem Vergleichsergebnis, wobei die Auswerteeinheit (6) dazu eingerichtet ist, eine korrekte Funktion der Leuchtdiodeneinheit (1) zu ermitteln, wenn während des Ladevorgangs anhand des Vergleichsergebnisses ermittelt wurde, dass sich die extern anliegende elektrische Ladespannung ($U_{Ext}$) nicht weiter erhöht, und
- die Testeinrichtung (3) dazu eingerichtet ist, den Ladevorgang nach dem Ermitteln der korrekten Funktion sofort abzubrechen, sodass kein signifikanter elektrischer Strom, welcher eine Leuchtwirkung aufweist, die von dem menschlichen Auge wahrgenommen werden kann, durch die Leuchtdioden der Leuchtdiodeneinheit (1) fließt.

12. Testeinrichtung (3) nach Anspruch 11, ferner aufweisend:

- eine zusätzliche Kurzschlussermittlungsschaltung (7)

- mit einem ersten Eingang (+), an dem eine an der Leuchtdiodeneinheit (1) abfallende elektrische Spannung ($U_{LED}$) anliegt,
- mit einem zweiten Eingang (-), an dem eine Referenzspannung ($U_{min\_Ref}$) anliegt,

- mit einer Vergleichseinheit (K), welche dazu eingerichtet ist, einen Vergleich der Spannungswerte der an der Leuchtdiodeneinheit (1) abfallenden elektrischen Spannung ($U_{LED}$) und der Referenzspannung ($U_{min\_Ref}$) durchzuführen, wobei die Auswerteeinheit (6) dazu eingerichtet ist, in Abhängigkeit von dem ermittelten Vergleichsergebnis ($U_{Ext\_min\_OK}$) zu ermitteln, ob in der Leuchtdiodeneinheit (1) ein elektrischer Kurzschluss vorliegt oder nicht.

13. Lichtzeichenanlage (10, 20, 40, 50), aufweisend:

- eine Lichtzeichenanzeige mit einer Leuchtdiodeneinheit (1),
- eine Ansteuerungsschaltung (2) zum Ansteuern der Leuchtdiodeneinheit (1) im Normalbetrieb,
- eine Testeinrichtung (3) nach Anspruch 11 oder 12.

14. Computerprogrammprodukt mit einem Computerprogramm, welches direkt in eine Speichereinrichtung einer Testeinrichtung (3) nach Anspruch 11 oder 12 ladbar ist, mit Programmabschnitten, um alle Schritte des Verfahrens nach einem der Ansprüche 1 bis 10 auszuführen, wenn das Computerprogramm in der Testeinrichtung (3) ausgeführt wird.

15. Computerlesbares Medium, auf welchem von einer Rechnereinheit einlesbare und ausführbare Programmabschnitte gespeichert sind, um alle Schritte des Verfahrens nach einem der Ansprüche 1 bis 10 auszuführen, wenn die Programmabschnitte von der Rechnereinheit ausgeführt werden.

**Claims**

1. Method for monitoring the function of an LED unit (1), having the steps:

- applying a first constant current ($I_{Test}$, $I_{Test1}$) to a supply line (ZL) of the LED unit (1) for charging a capacitance formed by the supply line (ZL) and the LED unit (1) by means of the first constant current ($I_{Test}$, $I_{Test1}$),
- determining an external electric charging voltage ($U_{Ext}$) applied to the supply line (ZL) during the charging process, **characterised by**:
- carrying out a comparison on the basis of a time derivative of the determined external electric charging voltage ($U_{Ext}$) and a reference value ($U_{Ref}$, $dU/dt_{Ref}$),
- determining a correct function of the LED unit (1) as a function of the comparison result, wherein a correct function of the LED unit (1) is determined, if, during the charging process, it was determined on the basis of the comparison result that the externally applied electric charging voltage ($U_{Ext}$) does not increase further,
- immediate interruption of the charging process after determining the correct function so that no significant electric current, which has a lighting effect which can be perceived by the human eye, flows through the LEDs of the LED unit (1).

2. Method according to claim 1, having the steps:

- applying a second constant current ($I_{Test2}$) to a reference capacitance ($C_{Ref}$),
- determining an internal electric charging voltage ($U_{Ref}$) applied to the reference capacitance ($C_{Ref}$) as a reference value ($U_{Ref}$).

3. Method according to claim 2, wherein with the method step a voltage difference ($U_D$) is determined between the external electric charging voltage ($U_{Ext}$) and the internal electric charging voltage ($U_{Ref}$).

4. Method according to claim 3, wherein the determination of a correct function comprises a comparison of the determined voltage difference ($U_D$) with a predetermined threshold value (Us).

5. Method according to claim 4, wherein a constant current source (4) generating the first ($I_{Test1}$) and/or the second constant current ($I_{Test2}$) is switched off when the determined voltage difference ($U_D$) has reached the predetermined threshold value ($U_S$).

6. Method according to one of claims 2 to 5, wherein after reaching a forward voltage ($U_{DL}$) of the LED unit (1) the line capacitance ($C_L$), on account of the current flow to be used through LEDs ($D_L$) of the LED unit (1), is not charged further and at the same time an internal reference capacitance ($C_{Ref}$) is further charged by the second constant current ($I_{Test2}$) so that the voltage difference ($U_D$) to be determined occurs between the external electric charging voltage ($U_{Ext}$) and an internal electric charging voltage ($U_{Ref}$).

7. Method according to claim 5 or 6, wherein the constant current source (4) is switched off before a significant current flow occurs through the LEDs ($D_L$) of the LED unit (1).

8. Method according to one of claims 4 to 7, wherein in the instance that after a predetermined time interval exceedance of the predetermined threshold value ($U_s$) has not been determined by the determined voltage difference ($U_D$), a fault is established in the LED unit (1).

9. Method according to one of claims 1 to 8, wherein

   - a value of an electric voltage ($U_{LED}$) dropping on the LED unit (1) is determined,
   - the determined voltage value ($U_{LED}$) is compared with a minimum voltage value ($U_{min\_Ref}$) and
   - as a function of the comparison between the determined voltage value ($U_{LED}$) and the minimum voltage value ($U_{min\_Ref}$), it is determined whether or not an electric short-circuit is present in the LED unit (1).

10. Method according to one of claims 4 to 8 and claim 9, wherein in the instance that it is determined that after a predetermined time interval either the predetermined threshold value ($U_s$) has not been reached by the determined voltage difference ($U_D$) or a value of the electric voltage ($U_{LED}$) dropping at the LED unit (1) has not reached the predetermined minimum voltage value ($U_{min\_Ref}$), a fault is established in the LED unit (1).

11. Test device (3) for monitoring an LED unit (1), having:

   - at least one constant current source (4) for applying a first constant current ($I_{Test}$, $I_{Test1}$) to a supply line (ZL) of the LED unit (1) for charging a capacitance formed by the supply line (ZL) and the LED unit (1) by means of the first constant current ($I_{Test}$, $I_{Test1}$),
   - a measuring unit (5)
   - having an input at which an external electric charging voltage ($U_{Ext}$) which is dropping at the supply line (ZL) of the LED unit (1) is present during the charging process, **characterised by**:
   - with a voltage comparison unit (T) for carrying out a voltage comparison on the basis of a time derivative of the external electric charging voltage ($U_{Ext}$) and a reference value ($U_{Ref}$, $dU/dt_{Ref}$),
   - an evaluation unit (6) for determining a correct function of the LED unit (1) as a function of the comparison result, wherein the evaluation unit (6) is designed to determine a correct function of the LED unit (1), if, during the charging process, it was determined on the basis of the comparison result that the externally applied electric charging voltage ($U_{Ext}$) is not increased further, and
   - the test facility (3) is designed to immediately interrupt the charging process after determining the correct function so that no significant electric current, which has a lighting effect which can be perceived by the human eye, flows through the LEDs of the LED unit (1).

12. Test facility (3) according to claim 11, further having:

   - an additional short-circuit determination circuit (7)

     - with a first input (+), at which an electric voltage ($U_{LED}$) dropping at the LED unit (1) is applied,
     - with a second input (-) at which a reference voltage ($U_{min\_Ref}$) is applied,

   - with a comparison unit (K) which is designed to carry out a comparison of the voltage values of the electric voltage ($U_{LED}$) dropping at the LED unit (1) and the reference voltage ($U_{min\_Ref}$), wherein the evaluation unit (6) is designed to determine, as a function of the determined comparison result ($U_{Ext\_min\_OK}$), whether or not an electric short-circuit is present in the LED unit (1).

13. Set of lights (10, 20, 40, 50) having:

   - a set of lights with an LED unit (1),

- an activation circuit (2) for activating the LED unit (1) during normal operation,
- a test facility (3) according to claim 11 or 12.

14. Computer program product with a computer program, which can be loaded directly into a storage facility of a test facility (3) according to claim 11 or 12, with program sections for carrying out all steps of the method according to one of claims 1 to 10, when the computer program is executed in the test facility (3).

15. Computer-readable medium, upon which program sections which can be read in and carried out by a computer unit are stored, in order to carry out all steps of the method according to one of claims 1 to 10 when the program sections are carried out by the computer unit.

**Revendications**

1. Procédé de contrôle du fonctionnement d'une unité (1) à diodes électroluminescentes, comportant les stades :

   - on applique un premier courant ($I_{Test}$, $I_{Test1}$) constant à une ligne (ZL) d'alimentation de l'unité (1) à diodes électroluminescentes pour charger, par le premier courant ($I_{Test}$, $I_{Test1}$) constant, une capacité formée par la ligne (ZL) d'alimentation et l'unité (1) à diodes électroluminescentes,
   - on détermine une tension ($U_{Ext}$) de charge électrique extérieure s'appliquant à la ligne (ZL) d'alimentation pendant l'opération de charge,

   **caractérisé en ce que** :

   - on effectue une comparaison sur la base d'une dérivée en fonction du temps de la tension ($U_{Ext}$) de charge électrique extérieure déterminée et d'une valeur ($U_{Ref}$, $dU/dt_{Ref}$) de référence,
   - on détermine un fonctionnement correct de l'unité (1) à diodes électroluminescentes en fonction du résultat de la comparaison, un fonction correct de l'unité (1) à diodes électroluminescentes étant déterminé si pendant l'opération de charge on a déterminé, à l'aide du résultat de la comparaison, que la tension ($U_{Ext}$) de charge électrique s'appliquant de l'extérieur ne s'élève pas davantage,
   - on interrompt immédiatement l'opération de charge après la détermination du fonctionnement correct, de manière à ce qu'il ne passe pas, dans les diodes électroluminescentes de l'unité (1) à diodes électroluminescentes, de courant électrique significatif, qui a un effet d'éclairage pouvant être perceptible par l'œil humain.

2. Procédé suivant la revendication 1, comprenant le stades :

   - on applique un deuxième courant ($I_{Test2}$) constant à une capacité ($C_{Ref}$) de référence,
   - on détermine comme valeur ($U_{Ref}$) de référence une tension ($U_{Ref}$) de charge électrique intérieure s'appliquant à la capacité ($C_{Ref}$) de référence.

3. Procédé suivant la revendication 2, dans lequel, dans le stade de comparaison, on détermine une différence ($U_D$) de tension entre la tension ($U_{Ext}$) de charge électrique extérieure et la tension ($U_{Ref}$) de charge électrique intérieure.

4. Procédé suivant la revendication 3, dans lequel la détermination d'un fonctionnement correct comprend une comparaison de la différence ($U_D$) de tension déterminée à une valeur ($U_S$) de seuil définie à l'avance.

5. Procédé suivant la revendication 4, dans lequel on met hors circuit une source (4) de courant constant produisant le premier ($I_{Test1}$) et/ou le deuxième courant ($I_{Test2}$) constant si la différence ($U_D$) de tension déterminée a atteint la valeur ($U_S$) de seuil définie à l'avance.

6. Procédé suivant l'une des revendications 2 à 5, dans lequel on ne charge pas davantage la capacité ($C_L$) de ligne après avoir atteint une tension ($U_{DL}$) directe de l'unité (1) à diodes électroluminescentes, en raison du flux ($I_{Led}$) de courant utilisé dans les diodes ($D_L$) électroluminescentes de l'unité (1) à diodes électroluminescentes et, en même temps, on charge davantage une capacité ($C_{Ref}$) de référence intérieure par le deuxième courant ($I_{Test2}$) constant dès que la différence ($U_D$) de tension déterminée entre la tension ($U_{Ext}$) de charge électrique extérieure et une tension ($U_{Ref}$) de charge électrique intérieure apparaît.

7. Procédé suivant la revendication 5 ou 6, dans lequel une mise hors circuit de la source (4) de courant constant a lieu avant qu'un flux de courant significatif dans les diodes ($D_L$) électroluminescentes de l'unité (1) à diodes électroluminescentes n'apparaisse.

8. Procédé suivant l'une des revendications 4 à 7, dans lequel, dans le cas où, après un intervalle de temps défini à l'avance, on n'a pas déterminé de dépassement de la valeur ($U_S$) de seuil définie à l'avance par la différence ($U_D$) de tension déterminée, on constate un défaut de l'unité (1) à diodes électroluminescentes.

9. Procédé suivant l'une des revendications 1 à 8, dans lequel

   - on détermine une valeur d'une tension ($U_{LED}$) électrique chutant aux bornes de l'unité (1) à diodes électroluminescentes,
   - on compare la valeur ($U_{LED}$) de tension déterminée à une valeur ($U_{min\_Ref}$) de tension minimum et
   - en fonction de la comparaison entre la valeur ($U_{LED}$) de tension déterminée et la valeur ($U_{min\_Ref}$) de tension minimum, on détermine s'il y a ou non un court-circuit électrique dans l'unité (1) à diodes électroluminescentes.

10. Procédé suivant l'une des revendications 4 à 8 et la revendication 9, dans lequel, dans le cas où l'on détermine qu'après un intervalle de temps défini à l'avance, ou bien la valeur ($U_S$) de seuil définie à l'avance n'a pas été atteinte par la différence ($U_D$) de tension déterminée, ou bien une valeur de la tension ($U_{LED}$) électrique chutant aux bornes de l'unité (1) à diodes électroluminescentes n'a pas atteint la valeur ($U_{min\_Ref}$) de tension minimum définie à l'avance, on constate un défaut de l'unité (1) à diodes électroluminescentes.

11. Dispositif (3) de test pour le contrôle d'une unité (1) à diodes électroluminescentes, comportant :

   - au moins une source (4) de courant constant pour appliquer un premier courant ($I_{Test}$, $I_{Test1}$) constant à une ligne (ZL) d'alimentation de l'unité (1) à diodes électroluminescentes pour charger, par le premier courant ($I_{Test}$, $I_{Test1}$) constant, une capacité formée par la ligne (ZL) d'alimentation et l'unité (1) à diodes électroluminescentes,
   - une unité (5) de mesure

      - ayant une entrée à laquelle s'applique, pendant l'opération de charge, une tension ($U_{Ext}$) de charge électrique extérieure chutant aux bornes de la ligne (ZL) d'alimentation de l'unité (1) à diodes électroluminescentes,
      **caractérisé par**
      - une unité (T) de comparaison de tension pour effectuer une comparaison de tension sur la base d'une dérivée en fonction du temps de la tension ($U_{Ext}$) de charge électrique extérieure et d'une valeur ($U_{Ref}$, $dU/dt_{Ref}$) de référence,

      - une unité (6) d'exploitation pour déterminer un fonctionnement correct de l'unité (1) à diodes électroluminescentes en fonction du résultat de la comparaison, l'unité (6) d'exploitation étant conçu pour déterminer un fonctionnement correct de l'unité (1) à diodes électroluminescentes s'il a été déterminé, pendant l'opération de charge, à l'aide du résultat de la comparaison, que la tension ($U_{Ext}$) de charge électrique s'appliquant extérieurement ne s'élève pas davantage, et
      - le dispositif (3) de test est conçu pour interrompre immédiatement l'opération de charge après la détermination du fonctionnement correct, de manière à ce qu'il ne passe pas, dans les diodes électroluminescentes de l'unité (1) à diodes électroluminescentes, de courant électrique significatif, qui a un effet d'éclairage perceptible par l'œil humain.

12. Dispositif (3) de test suivant la revendication 11, comportant, en outre :

   - un circuit (7) supplémentaire de détermination d'un court-circuit,

      - ayant une première entrée (+) où s'applique une tension ($U_{LED}$) chutant aux bornes de l'unité (1) à diodes électroluminescentes,
      - une deuxième entrée (-) où s'applique une tension ($U_{min\_Ref}$) de référence,
      - une unité (K) de comparaison, conçue pour effectuer une comparaison des valeurs de tension de la tension ($U_{LED}$) électrique chutant aux bornes de l'unité (1) à diodes électroluminescentes et de la tension ($U_{min\_Ref}$) de référence,
      l'unité (6) d'exploitation étant conçue pour déterminer, en fonction du résultat ($U_{Ext\_min\_OK}$) de comparaison déterminée, s'il y a ou non un court-circuit électrique dans l'unité (1) à diodes électroluminescentes.

**13.** Installation (10, 20, 40, 50) à signal lumineux, comportant :

- un affichage à signal lumineux ayant une unité (1) à diodes électroluminescentes,
- un circuit (2) de commande pour commander l'unité (1) à diodes électroluminescentes en fonctionnement normal,
- un dispositif (3) de test suivant la revendication 11 ou 12.

**14.** Produit de programme d'ordinateur ayant un programme d'ordinateur, qui peut être chargé directement dans un dispositif de mémoire d'un dispositif (3) de test suivant la revendication 11 ou 12 et qui a des parties de programme pour effectuer tous les stades du procédé suivant l'une des revendications 1 à 10, lorsque le programme d'ordinateur est réalisé dans le dispositif (3) de test.

**15.** Support déchiffrable par ordinateur, sur lequel sont mises en mémoire des parties de programme pouvant être lues et réalisées par une unité de calcul, afin d'effectuer tous les stades du procédé suivant l'une des revendications 1 à 10, lorsque les parties de programme sont exécutées par l'unité de calcul.

# FIG 1

FIG 2

EP 3 236 713 B1

# FIG 3

300

EP 3 236 713 B1

FIG 4

40

2

$I_{Ext\_B}$

3

$I_{LED\_OK}$

8

1

$U_{Ext}$

6

ST

$I_{Test}$

ZL

41

4

22

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1417864 B1
- US 20070096746 A1
- AT 512751A1
- EP 2882260 A1
- DE 102015100605 A1
- US 20150331034 A1
- US 20090027314 A1
- US 20160103170 A1
- WO 2010034509 A2
- WO 2010060458 A1